# EUROPEAN PATENT APPLICATION

(11) **EP 4 365 901 A1**
(43) Date of publication of application: **08.05.2024**
(21) Application number: 21954624.9
(22) Date of filing: 27.08.2021
(51) Int. Cl.: G11C 11/22, H10B 53/00

(54) **FERROELECTRIC MEMORY AND FORMATION METHOD THEREFOR, AND ELECTRONIC DEVICE**

(71) Applicant: Huawei Technologies Co., Ltd., Longgang Shenzhen, Guangdong 518129 (CN)
(72) Inventor: TAN, Wanliang, Shenzhen, Guangdong 518129 (CN); LI, Yuxing, Shenzhen, Guangdong 518129 (CN); LI, Weigu, Shenzhen, Guangdong 518129 (CN); CAI, Jialin, Shenzhen, Guangdong 518129 (CN); LV, Hangbing, Shenzhen, Guangdong 518129 (CN); XU, Jeffrey Junhao, Shenzhen, Guangdong 518129 (CN)
(74) Representative: Maiwald GmbH
(86) International application number: PCT/CN2021/115134
(87) International publication number: WO 2023/024101

(57) **Abstract**

Embodiments of this application provide a ferroelectric memory and a forming method thereof, and an electronic device including the ferroelectric memory, to mainly suppress diffusion of an oxygen element in a ferroelectric layer. The ferroelectric memory includes a substrate and a plurality of memory cells formed on the substrate. Each memory cell includes a ferroelectric capacitor. The ferroelectric capacitor includes a first electrode and a second electrode, and a ferroelectric layer formed between the first electrode and the second electrode. The ferroelectric capacitor further includes a first isolation passivation layer formed between the first electrode and the ferroelectric layer, and a second isolation passivation layer formed between the second electrode and the ferroelectric layer. The first isolation passivation layer is configured to suppress diffusion of the oxygen element in the ferroelectric layer to the first electrode, and the second isolation passivation layer is configured to suppress diffusion of the oxygen element in the ferroelectric layer to the second electrode. In this way, the first isolation passivation layer and the second isolation passivation layer are used as protective barriers to isolate and protect the ferroelectric layer, to prevent the oxygen element in the ferroelectric layer from diffusing.

## Description

### TECHNICAL FIELD

This application relates to the field of semiconductor storage technologies, and in particular, to a ferroelectric memory and a forming method thereof, and an electronic device including the ferroelectric memory.

### BACKGROUND

As a new type of memories, ferroelectric random access memories (ferroelectric random access memories, FeRAMs) are more widely used than conventional memories such as dynamic random access memories (dynamic random access memories, DRAMs) or flash memories because of advantages such as non-volatility, a high speed, low power consumption, and sufficient read/write times.

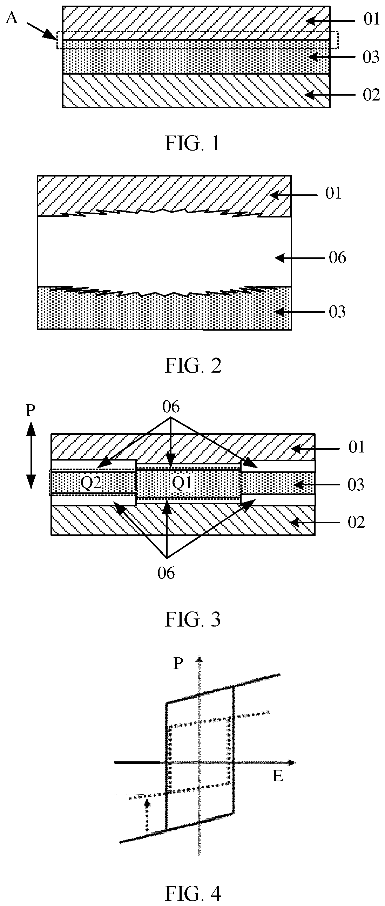

FIG. 1 is a diagram of a process structure of a ferroelectric capacitor in a core part of a FeRAM. The ferroelectric capacitor includes a first electrode 01 and a second electrode 02 that are stacked, and a ferroelectric layer 03 formed between the first electrode 01 and the second electrode 02. Usually, the first electrode 01 and the second electrode 02 are made of a metal material. Therefore, the ferroelectric capacitor may be referred to as a metal-ferroelectric-metal (metal-ferroelectric-metal, MFM) ferroelectric capacitor structure.

FIG. 2 is an enlarged diagram of an interface A between the first electrode 01 and the ferroelectric layer 03 in FIG. 1. To be specific, FIG. 2 shows that a dead layer 06 is formed at the interface between the first electrode 01 and the ferroelectric layer 03. For example, when the material of the first electrode 01 includes titanium nitride TiN, and a material of the ferroelectric layer 03 includes hafnium oxide HfO₂, the dead layer 06 is formed because in a high temperature deposition process or an annealing process, element diffusion occurs between the TiN first electrode 01 and the HfO₂ ferroelectric layer 03, and the TiN first electrode 01 obtains an oxygen element in HfO₂. In an aspect, TiOxNy is formed. In another aspect, the HfO₂ ferroelectric layer 03 is oxygen-deficient and becomes HfO₍₂₋ₓ₎. In this way, the dead layer 06 that includes at least TiOxNy and HfO₍₂₋ₓ₎ is formed. The dead layer 06 not only appears at the interface between the first electrode 01 and the ferroelectric layer 03 in FIG. 1, but also may appear at an interface between the second electrode 02 and the ferroelectric layer 03 in FIG. 1.

FIG. 3 is a diagram of a process structure of a ferroelectric capacitor in which dead layers 06 are formed. In addition, the dead layer 06 is formed at both an interface between a first electrode 01 and a ferroelectric layer 03 and an interface between a second electrode 02 and the ferroelectric layer 03. In a specific process structure, thicknesses of the dead layers 06 in a stacking direction (for example, a P direction in FIG. 3) of layer structures of the ferroelectric capacitor are not uniform. For example, as shown in FIG. 3, thicknesses of some dead layers 06 are large, and thicknesses of some dead layers 06 are small. In this case, polarization occurs in an area Q1 that is of the ferroelectric layer 03 and that corresponds to a thin dead layer 06, and a ferroelectric phase is presented. However, polarization is weak in an area Q2 that is of the ferroelectric layer 03 and for which an opposite dead layer 06 is thick, and even a ferroelectric phase cannot be presented. Consequently, a quantity of ferroelectric phase grains in the ferroelectric layer 03 is reduced, resulting in reduction of ferroelectric performance of the ferroelectric capacitor, and affecting a read/write function.

In addition, because the dead layer 06 is formed by taking oxygen in a ferroelectric material away by a metal in an electrode, the ferroelectric material is in an oxygen-deficient state. An increase of an oxygen vacancy causes a case in which a conductive filament (which may also be referred to as a leakage channel) is easily formed at the ferroelectric layer 03 during positive and negative voltage cycling of the ferroelectric capacitor. Consequently, the ferroelectric capacitor is broken down, and the ferroelectric capacitor may fail.

FIG. 4 is a curve diagram of ferroelectric performance affected by a dead layer 06. A horizontal coordinate represents electric field strength E loaded to a ferroelectric layer 03, a vertical coordinate represents polarization intensity P of the ferroelectric layer 03, a black solid line represents a polarization intensity curve when there is no dead layer 06, and a black dotted line represents a polarization intensity curve when there is a dead layer 06. It is clear that when there is the dead layer 06, the polarization intensity deteriorates, ferroelectricity deteriorates, and storage performance of a memory is also obviously reduced.

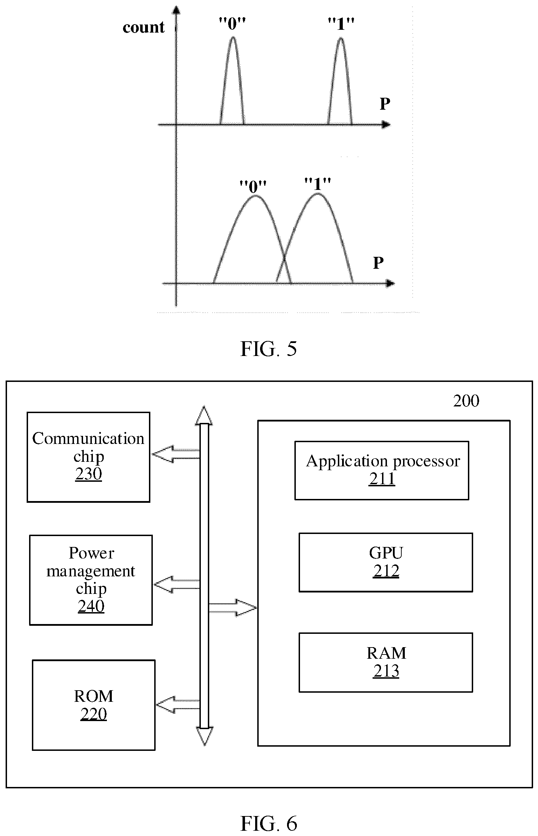

In addition, FIG. 5 shows polarization state distribution curves when a memory has a dead layer 06 and when the memory has no dead layer 06. The upper two curves represent distribution curves of logic states "0" and "1" when there is no dead layer 06, and the lower two curves represent distribution curves of the logic states "0" and "1" when there is the dead layer 06. It can be learned that when there is no dead layer 06, a state difference between the logical states "0" and "1" is great. However, when there is the dead layer 06, the state difference between the logical states "0" and "1" is obviously reduced. As a result, storage performance of the memory is reduced.

### SUMMARY

This application provides a ferroelectric memory and a forming method thereof, and an electronic device including the ferroelectric memory, to mainly provide a ferroelectric memory that can suppress diffusion of an oxygen element in a ferroelectric layer, suppress formation of a non-ferroelectric dead layer, and improve ferroelectric performance.

To achieve the foregoing objective, the following technical solutions are used in embodiments of this application.

According to a first aspect, this application provides a ferroelectric memory. The memory is a ferroelectric random access memory (ferroelectric random access memory, FeRAM). The ferroelectric memory includes a substrate and a plurality of memory cells formed on the substrate. Each memory cell includes a ferroelectric capacitor. The ferroelectric capacitor includes a first electrode and a second electrode that are stacked, and a ferroelectric layer formed between the first electrode and the second electrode as a storage medium. A storage medium material of the ferroelectric layer includes a hafnium oxide based material. In addition, the ferroelectric capacitor further includes a first isolation passivation layer formed between the first electrode and the ferroelectric layer, and a second isolation passivation layer formed between the second electrode and the ferroelectric layer. The first isolation passivation layer is configured to suppress diffusion of an oxygen element in the ferroelectric layer to the first electrode, and the second isolation passivation layer is configured to suppress diffusion of the oxygen element in the ferroelectric layer to the second electrode. In other words, the first isolation passivation layer and the second isolation passivation layer herein are used as protective barriers to isolate and protect the ferroelectric layer.

In the memory cell of the ferroelectric memory provided in this application, the ferroelectric capacitor configured to store a charge not only includes the first electrode, the second electrode, and the ferroelectric layer stacked between the first electrode and the second electrode, but also includes the first isolation passivation layer and the second isolation passivation layer. In this case, the first isolation passivation layer is disposed between the first electrode and the ferroelectric layer, so that the oxygen element in the ferroelectric layer does not diffuse to the first electrode, and a dead layer that cannot present a ferroelectric phase is not formed between the first electrode and the ferroelectric layer. Similarly, the second isolation passivation layer can also suppress the diffusion of the oxygen element in the ferroelectric layer to the second electrode, so that the dead layer that cannot present the ferroelectric phase is not formed between the second electrode and the ferroelectric layer. In this way, a deficiency of the oxygen element due to oxygen diffusion does not occur at the ferroelectric layer, and a phenomenon of a leakage channel does not occur inside the ferroelectric layer. Therefore, a phenomenon that the ferroelectric capacitor is broken down can be avoided.

Based on the foregoing descriptions, in this application, the first isolation passivation layer and the second isolation passivation layer are disposed, so that a quantity of grains that present the ferroelectric phase in the ferroelectric layer can be increased, and ferroelectricity of the memory cell can be improved, thereby improving storage performance of the memory.

In a possible implementation of the first aspect, the first isolation passivation layer and/or the second isolation passivation layer include/includes a metal material having chemical inertia. Chemical inertia of the first isolation passivation layer is greater than both chemical inertia of the ferroelectric layer and chemical inertia of the first electrode. Chemical inertia of the second isolation passivation layer is greater than both the chemical inertia of the ferroelectric layer and chemical inertia of the second electrode.

Either of the first isolation passivation layer and the second isolation passivation layer is made of the metal material having chemical inertia, so that the chemical inertia of the metal material can be used to prevent the oxygen element from diffusing to an electrode layer.

In a possible implementation of the first aspect, the first isolation passivation layer and/or the second isolation passivation layer include/includes at least one of metal oxide and a metal simple substance.

In a possible implementation of the first aspect, the foregoing metal oxide may be a metal oxide dielectric material, or may be a metal oxide conductive material.

In a possible implementation of the first aspect, metal oxide such as titanium oxide (TiO₂), tungsten oxide (WO₃), tantalum oxide (TazOs), niobium oxide (NbzOs), aluminum oxide (Al₂O₃), magnesium oxide (MgO), or cerium oxide (CeO₂), or a metal simple substance such as platinum (Pt) or palladium (Pd) may be selected for the first isolation passivation layer and/or the second isolation passivation layer.

In a possible implementation of the first aspect, the first isolation passivation layer includes an amorphous structure and/or an orthorhombic crystalline phase structure. The second isolation passivation layer includes the amorphous structure and/or the orthorhombic crystalline phase structure. The first isolation passivation layer is further configured to suppress impact of the first electrode on a crystalline orientation of the ferroelectric layer. The second isolation passivation layer is further configured to suppress impact of the second electrode on the crystalline orientation of the ferroelectric layer. In addition, the first isolation passivation layer and the second isolation passivation layer enable the ferroelectric layer to present an orthorhombic crystalline phase.

In other words, when the first isolation passivation layer includes at least one of the amorphous structure and the orthorhombic crystalline phase structure, the first isolation passivation layer can not only suppress the diffusion of the oxygen element in the ferroelectric layer, but also suppress the impact of the first electrode on the crystalline orientation of the ferroelectric layer. Similarly, when the second isolation passivation layer includes at least one of the amorphous structure and the orthorhombic crystalline phase structure, the second isolation passivation layer can not only suppress the diffusion of the oxygen element in the ferroelectric layer, but also suppress the impact of the second electrode on the crystalline orientation of the ferroelectric layer. Finally, the ferroelectric layer is preferably selected to present an orthorhombic crystalline phase having good ferroelectricity.

In a possible implementation of the first aspect, the first isolation passivation layer and/or the second isolation passivation layer include/includes at least one of titanium oxide, tungsten oxide, and aluminum oxide.

In a possible implementation of the first aspect, the first electrode, the first isolation passivation layer, the ferroelectric layer, the second isolation passivation layer, and the second electrode are stacked in a direction parallel to the substrate.

A ferroelectric capacitor formed in this way may be referred to as a vertical ferroelectric capacitor structure. The ferroelectric capacitor structure may implement three-dimensional integration on the substrate, and increase storage density of the memory, to meet a fast computing requirement of an electronic device.

In a possible implementation of the first aspect, the first electrode extends in a direction perpendicular to the substrate. The first isolation passivation layer, the ferroelectric layer, the second isolation passivation layer, and the second electrode sequentially surround the periphery of the first electrode in a direction parallel to the substrate.

In this way, a formed ferroelectric capacitor is of a column structure perpendicular to the substrate, and a cross section of the column structure may be a circle, a rectangle, or another shape.

In a possible implementation of the first aspect, the first electrode, the first isolation passivation layer, the ferroelectric layer, the second isolation passivation layer, and the second electrode are stacked in a direction perpendicular to the substrate.

A ferroelectric capacitor formed in this way may be referred to as a planar ferroelectric capacitor structure.

In a possible implementation of the first aspect, a thickness of the first isolation passivation layer and/or a thickness of the second isolation passivation layer in a stacking direction of the first electrode and the second electrode are/is 0.5 nm to 5 nm.

In this way, not only an objective of suppressing formation of a dead layer can be achieved, but also a chemical reaction between an electrode layer and the ferroelectric layer can be avoided, so that an oxygen balance of the ferroelectric layer is maintained, thereby improving ferroelectricity of the ferroelectric layer.

In a possible implementation of the first aspect, each memory cell further includes a first transistor, a second transistor, a control line, a write bit line, a read bit line, a source line, and a word line. A control end of the first transistor is electrically connected to the control line, a first end of the first transistor is electrically connected to the first electrode, and a second end of the first transistor is electrically connected to the write bit line. A control end of the second transistor is electrically connected to the first electrode, a first end of the second transistor is electrically connected to the source line, and a second end of the second transistor is electrically connected to the read bit line. The second electrode is electrically connected to the word line.

In a possible implementation of the first aspect, each memory cell includes at least two ferroelectric capacitors.

In 2TnC memory cells formed in this way, a memory cell may be configured to store multi-bit data, to increase a storage capacity of each memory cell.

According to a second aspect, this application provides a ferroelectric memory. The memory is also a FeRAM, which is the same as the memory in the embodiment of the first aspect. The ferroelectric memory includes a substrate and a plurality of memory cells formed on the substrate. Each memory cell includes a ferroelectric capacitor. The ferroelectric capacitor includes a first electrode and a second electrode that are stacked, and a ferroelectric layer formed between the first electrode and the second electrode as a storage medium. The ferroelectric layer includes a hafnium oxide based material. In addition, the ferroelectric capacitor further includes a first isolation passivation layer formed between the first electrode and the ferroelectric layer, and a second isolation passivation layer formed between the second electrode and the ferroelectric layer. The first isolation passivation layer and/or the second isolation passivation layer include/includes at least one of titanium oxide, tungsten oxide, tantalum oxide, niobium oxide, magnesium oxide, platinum, and palladium.

In the memory cell of the ferroelectric memory provided in this application, the ferroelectric capacitor configured to store a charge not only includes the first electrode, the second electrode, and the ferroelectric layer stacked between the first electrode and the second electrode, but also includes the first isolation passivation layer and the second isolation passivation layer. In addition, at least one of the first isolation passivation layer and the second isolation passivation layer includes at least one of titanium oxide, tungsten oxide, tantalum oxide, niobium oxide, aluminum oxide, magnesium oxide, cerium oxide, platinum, and palladium. When titanium oxide, tungsten oxide, tantalum oxide, niobium oxide, aluminum oxide, magnesium oxide, cerium oxide, platinum, or palladium is used as a material of the isolation passivation layer, because these materials have characteristics of strong chemical inertia and high chemical stability, diffusion of an oxygen element in the ferroelectric layer to the corresponding first electrode and the corresponding second electrode can be suppressed, and an oxygen element in these materials does not diffuse to the first electrode and the second electrode either. In comparison with the conventional technology, formation of a dead layer can be suppressed, a deficiency of the oxygen element does not occur at the ferroelectric layer, and a phenomenon of a leakage channel does not occur inside the ferroelectric layer. Therefore, the first isolation passivation layer and the second isolation passivation layer are introduced, so that ferroelectricity of the ferroelectric capacitor can be improved, thereby improving storage performance.

In a possible implementation of the second aspect, the first isolation passivation layer includes an amorphous structure and/or an orthorhombic crystalline phase structure. The second isolation passivation layer includes the amorphous structure and/or the orthorhombic crystalline phase structure. The first isolation passivation layer is further configured to suppress impact of the first electrode on a crystalline orientation of the ferroelectric layer. The second isolation passivation layer is further configured to suppress impact of the second electrode on the crystalline orientation of the ferroelectric layer. In addition, the first isolation passivation layer and the second isolation passivation layer enable the ferroelectric layer to present an orthorhombic crystalline phase.

In this way, the first isolation passivation layer and the second isolation passivation layer can not only suppress the diffusion of the oxygen element in the ferroelectric layer, but also enable crystals in the ferroelectric layer to be of an orthorhombic crystalline phase structure, so that the ferroelectricity of the ferroelectric layer is further improved, thereby improving the storage performance of the memory.

In a possible implementation of the second aspect, the first electrode, the first isolation passivation layer, the ferroelectric layer, the second isolation passivation layer, and the second electrode are stacked in a direction perpendicular to the substrate.

A ferroelectric capacitor formed in this way may be referred to as a vertical ferroelectric capacitor structure. The vertical ferroelectric capacitor structure occupies a small area, so that high-density integration can be implemented, thereby increasing a storage capacity.

In a possible implementation of the second aspect, the first electrode, the first isolation passivation layer, the ferroelectric layer, the second isolation passivation layer, and the second electrode are stacked in a direction parallel to the substrate.

A ferroelectric capacitor formed in this way may be referred to as a planar ferroelectric capacitor structure.

In a possible implementation of the second aspect, each memory cell further includes a first transistor, a second transistor, a control line, a write bit line, a read bit line, a source line, and a word line. A control end of the first transistor is electrically connected to the control line, a first end of the first transistor is electrically connected to the first electrode, and a second end of the first transistor is electrically connected to the write bit line. A control end of the second transistor is electrically connected to the first electrode, a first end of the second transistor is electrically connected to the source line, and a second end of the second transistor is electrically connected to the read bit line. The second electrode is electrically connected to the word line.

In a possible implementation of the second aspect, a thickness of the first isolation passivation layer and/or a thickness of the second isolation passivation layer in a stacking direction of the first electrode and the second electrode are/is 0.5 nm to 5 nm.

According to a third aspect, this application further provides a method for manufacturing a FeRAM. The manufacturing method includes:
forming a first electrode, a second electrode, a ferroelectric layer, a first isolation passivation layer, and a second isolation passivation layer on a substrate, where the ferroelectric layer is formed between the first electrode and the second electrode, the first isolation passivation layer is formed between the first electrode and the ferroelectric layer, the second isolation passivation layer is formed between the second electrode and the ferroelectric layer, and the ferroelectric layer is made of a material including a hafnium oxide based material; and
annealing the first electrode, the second electrode, the ferroelectric layer, the first isolation passivation layer, and the second isolation passivation layer, to obtain a ferroelectric capacitor including the first electrode, the second electrode, the ferroelectric layer, the isolation passivation layer, and the second isolation passivation layer, where the first isolation passivation layer is configured to suppress diffusion of an oxygen element in the ferroelectric layer to the first electrode, and the second isolation passivation layer is configured to suppress diffusion of the oxygen element in the ferroelectric layer to the second electrode.

In the method for forming the ferroelectric memory provided in this application, not only the first electrode and the second electrode that are configured to load a voltage, and the ferroelectric layer that is configured to store a charge are obtained, but also the first isolation passivation layer located between the first electrode and the ferroelectric layer and the second isolation passivation layer located between the second electrode and the ferroelectric layer are obtained. In this way, during annealing or another subsequent high-temperature process, the first isolation passivation layer may suppress the diffusion of the oxygen element in the ferroelectric layer to the first electrode. Similarly, the second isolation passivation layer may also suppress the diffusion of the oxygen element in the ferroelectric layer to the second electrode. Therefore, formation of a dead layer that presents a non-ferroelectric phase can be suppressed, so that a quantity of ferroelectric grains is increased, thereby improving ferroelectricity of the memory.

In a possible implementation of the third aspect, forming the first isolation passivation layer and/or the second isolation passivation layer includes: The first isolation passivation layer and the second isolation passivation layer are obtained by using a thin film deposition method.

In this way, a process method for manufacturing the first isolation passivation layer and the second isolation passivation layer can be compatible with a process of manufacturing another layer structure in the ferroelectric memory, so that a case in which a process is complex and manufacturing costs are increased because the isolation passivation layer structure needs to be added can be avoided.

In a possible implementation of the third aspect, the first isolation passivation layer and the second isolation passivation layer may be manufactured by using a deposition process such as physical vapor deposition, chemical vapor deposition, or atomic layer deposition. In this way, the manufactured isolation passivation layer can be uniform, have high flatness, and have high shape preservation. In other words, layer structures have basically a same shape and same surface flatness.

In a possible implementation of the third aspect, forming the first isolation passivation layer and/or the first isolation passivation layer includes: The first isolation passivation layer and the second isolation passivation layer are made of a metal material having chemical inertia. Chemical inertia of the first isolation passivation layer is greater than both chemical inertia of the ferroelectric layer and chemical inertia of the first electrode. Chemical inertia of the second isolation passivation layer is greater than both the chemical inertia of the ferroelectric layer and chemical inertia of the second electrode.

In a possible implementation of the third aspect, forming the first isolation passivation layer and/or the first isolation passivation layer includes: The first isolation passivation layer and the second isolation passivation layer are made of at least one of metal oxide and a metal. For example, a metal such as titanium oxide (TiO₂), tungsten oxide (WO₃), tantalum oxide (TazOs), niobium oxide (NbzOs), aluminum oxide (Al₂O₃), magnesium oxide (MgO), or cerium oxide (CeO₂), platinum (Pt), or palladium (Pd) may be used.

In a possible implementation of the third aspect, the forming a first electrode, a first isolation passivation layer, a ferroelectric layer, a second isolation passivation layer, and a second electrode includes: sequentially stacking the first electrode, the first isolation passivation layer, the ferroelectric layer, the second isolation passivation layer, and the second electrode in a direction perpendicular to the substrate.

In this way, a planar ferroelectric capacitor structure can be obtained.

In a possible implementation of the third aspect, the forming a first electrode, a first isolation passivation layer, a ferroelectric layer, a second isolation passivation layer, and a second electrode includes: sequentially stacking the first electrode, the first isolation passivation layer, the ferroelectric layer, the second isolation passivation layer, and the second electrode in a direction parallel to the substrate.

In this way, a vertical ferroelectric capacitor structure is obtained.

In a possible implementation of the third aspect, a thickness of the first isolation passivation layer and/or a thickness of the second isolation passivation layer in a stacking direction of the first electrode and the second electrode are/is 0.5 nm to 5 nm.

In this way, the first isolation passivation layer and the second isolation passivation layer can not only achieve an objective of suppressing the formation of the dead layer, but also maintain an oxygen balance of the ferroelectric layer, to improve the ferroelectricity of the ferroelectric layer.

In a possible implementation of the third aspect, forming the first isolation passivation layer and the second isolation passivation layer includes: The first isolation passivation layer and the second isolation passivation layer are made of an amorphous material.

When the first isolation passivation layer and the second isolation passivation layer are made of the amorphous material, a crystalline orientation of the ferroelectric layer cannot be affected by the first electrode and the second electrode, and the ferroelectric layer can be preferably selected to present an orthorhombic crystalline phase having good ferroelectricity.

According to a fourth aspect, this application provides a ferroelectric memory. The memory is a ferroelectric field-effect transistor (ferroelectric field-effect transistor, FeFET) memory. The ferroelectric memory includes a substrate and a plurality of memory cells formed on the substrate. Each memory cell includes a first doped area and a second doped area that are formed on the substrate, a channel area located between the first doped area and the second doped area, a ferroelectric layer that is formed on the channel area and that includes a hafnium oxide based material, and a gate formed on a side of the ferroelectric layer away from the substrate. Each memory cell further includes a first isolation passivation layer and a second isolation passivation layer. The first isolation passivation layer is formed between the ferroelectric layer and the channel area, and the second isolation passivation layer is formed between the ferroelectric layer and the gate. The first isolation passivation layer is configured to suppress diffusion of an oxygen element in the ferroelectric layer to the channel area, and the second isolation passivation layer is configured to suppress diffusion of the oxygen element in the ferroelectric layer to the gate.

In the memory cell of the ferroelectric memory provided in this application, one of the first doped area and the second doped area that are formed in the substrate may be a source, and the other doped area may be a drain. In this case, in addition to the source, the drain, the gate, and the channel structure, the memory cell further includes the first isolation passivation layer disposed between the ferroelectric layer and the channel area, and the second isolation passivation layer disposed between the ferroelectric layer and the gate. The first isolation passivation layer is disposed, so that a dead layer that cannot show a ferroelectric phase is formed between the channel area and the ferroelectric layer. The second isolation passivation layer is disposed, so that a dead layer that cannot show the ferroelectric phase is formed between the gate and the ferroelectric layer. In addition, the ferroelectric layer is not in an oxygen element-deficient state, so that no conductive filament (leakage channel) is formed during positive and negative voltage cycling of the memory cell due to an increase of oxygen vacancy in the ferroelectric layer, to cause a phenomenon that the storage ferroelectric layer is broken down.

In a possible implementation of the fourth aspect, the first isolation passivation layer and/or the second isolation passivation layer include/includes a metal material having chemical inertia. Chemical inertia of the first isolation passivation layer is greater than both chemical inertia of the ferroelectric layer and chemical inertia of the channel area. Chemical inertia of the second isolation passivation layer is greater than both the chemical inertia of the ferroelectric layer and chemical inertia of the gate.

The chemical inertia of these metal materials can be used to prevent an oxygen element from diffusing to an electrode layer.

In a possible implementation of the fourth aspect, the first isolation passivation layer and/or the second isolation passivation layer include/includes at least one of metal oxide and a metal.

In a possible implementation of the fourth aspect, a metal such as titanium oxide (TiO₂), tungsten oxide (WO₃), tantalum oxide (TazOs), niobium oxide (NbzOs), aluminum oxide (Al₂O₃), magnesium oxide (MgO), cerium oxide (CeO₂), platinum (Pt), or palladium (Pd) may be selected for the first isolation passivation layer and/or the second isolation passivation layer.

In a possible implementation of the fourth aspect, each memory cell further includes a word line, a bit line, and a source line. The gate is electrically connected to the word line, the first doped area is electrically connected to the bit line, and the second doped area is electrically connected to the source line.

In a possible implementation of the fourth aspect, a thickness of the first isolation passivation layer and/or a thickness of the second isolation passivation layer in a stacking direction of the ferroelectric layer and the gate are/is 0.5 nm to 5 nm.

In a possible implementation of the fourth aspect, the first isolation passivation layer includes an amorphous structure and/or an orthorhombic crystalline phase structure. The second isolation passivation layer includes the amorphous structure and/or the orthorhombic crystalline phase structure. The first isolation passivation layer is further configured to suppress impact of the channel area on a crystalline orientation of the ferroelectric layer. The second isolation passivation layer is further configured to suppress impact of the gate on the crystalline orientation of the ferroelectric layer. In addition, the first isolation passivation layer and the second isolation passivation layer enable the ferroelectric layer to present an orthorhombic crystalline phase.

In this way, not only the diffusion of the oxygen element in the ferroelectric layer can be suppressed, but also crystals in the ferroelectric layer are enabled to be of an orthorhombic crystalline phase structure, so that ferroelectricity of the ferroelectric layer is further improved, thereby improving storage performance of the memory.

According to a fifth aspect, this application provides a ferroelectric memory. The memory is also a FeFET memory, which is the same as the memory in the embodiment of the fourth aspect. The ferroelectric memory includes a substrate and a plurality of memory cells formed on the substrate. Each memory cell includes a first doped area and a second doped area that are formed on the substrate, a channel area located between the first doped area and the second doped area, a ferroelectric layer that is formed on the channel area and that includes a hafnium oxide based material, and a gate formed on a side of the ferroelectric layer away from the substrate. Each memory cell further includes a first isolation passivation layer and a second isolation passivation layer. The first isolation passivation layer is formed between the ferroelectric layer and the channel area, and the second isolation passivation layer is formed between the ferroelectric layer and the gate. The first isolation passivation layer and/or the second isolation passivation layer include/includes at least one of titanium oxide, tungsten oxide, tantalum oxide, niobium oxide, magnesium oxide, platinum, and palladium.

In the memory cell of the ferroelectric memory provided in this application, in addition to a source, a drain, the gate, and a channel structure, the memory cell further includes the first isolation passivation layer disposed between the ferroelectric layer and the channel area, and the second isolation passivation layer disposed between the ferroelectric layer and the gate. In addition, at least one of the first isolation passivation layer and the second isolation passivation layer includes at least one of titanium oxide, tungsten oxide, tantalum oxide, niobium oxide, aluminum oxide, magnesium oxide, cerium oxide, platinum, and palladium. When titanium oxide, tungsten oxide, tantalum oxide, niobium oxide, aluminum oxide, magnesium oxide, cerium oxide, platinum, or palladium is used as a material of the isolation passivation layer, because these materials have characteristics of strong chemical inertia and high chemical stability, diffusion of an oxygen element in the ferroelectric layer to the corresponding gate and the corresponding channel area can be suppressed. In comparison with the conventional technology, formation of a dead layer can be suppressed, a deficiency of the oxygen element does not occur at the ferroelectric layer, and a phenomenon of a leakage channel does not occur inside the ferroelectric layer.

In a possible implementation of the fifth aspect, the first isolation passivation layer includes an amorphous structure and/or an orthorhombic crystalline phase structure. The second isolation passivation layer includes the amorphous structure and/or the orthorhombic crystalline phase structure. The first isolation passivation layer is further configured to suppress impact of the channel area on a crystalline orientation of the ferroelectric layer. The second isolation passivation layer is further configured to suppress impact of the gate on the crystalline orientation of the ferroelectric layer. In addition, the first isolation passivation layer and the second isolation passivation layer enable the ferroelectric layer to present an orthorhombic crystalline phase.

In a possible implementation of the fifth aspect, each memory cell further includes a word line, a bit line, and a source line. The gate is electrically connected to the word line, the first doped area is electrically connected to the bit line, and the second doped area is electrically connected to the source line.

In a possible implementation of the fifth aspect, a thickness of the first isolation passivation layer and/or a thickness of the second isolation passivation layer in a stacking direction of the ferroelectric layer and the gate are/is 0.5 nm to 5 nm.

According to a sixth aspect, this application further provides a method for forming a ferroelectric memory. The forming method includes:
forming a first doped area and a second doped area in a substrate, and forming a ferroelectric layer, a gate, a first isolation passivation layer, and a second isolation passivation layer on the substrate, where the ferroelectric layer is formed on a channel area between the first doped area and the second doped area, the gate is formed on a side of the ferroelectric layer away from the substrate, the first isolation passivation layer is formed between the ferroelectric layer and the channel area, the second isolation passivation layer is formed between the ferroelectric layer and the gate, and the ferroelectric layer includes a hafnium oxide based material; and
annealing the gate, the ferroelectric layer, the first isolation passivation layer, and the second isolation passivation layer, where the first isolation passivation layer is configured to suppress diffusion of an oxygen element in the ferroelectric layer to the channel area, and the second isolation passivation layer is configured to suppress diffusion of the oxygen element in the ferroelectric layer to the gate.

In the method for forming the ferroelectric memory provided in this application, not only the first doped area, the second doped area, and the gate that are configured to load a voltage, and the ferroelectric layer that is configured to store a charge are obtained, but also the second isolation passivation layer located between the ferroelectric layer and the gate and the first isolation passivation layer located between the ferroelectric layer and the channel area are obtained. In this way, during annealing or another subsequent high-temperature process, the second isolation passivation layer may suppress the diffusion of the oxygen element in the ferroelectric layer to the gate, and the first isolation passivation layer may suppress the diffusion of the oxygen element in the ferroelectric layer to the channel area. Therefore, formation of a dead layer that presents a non-ferroelectric phase can be suppressed, so that a quantity of ferroelectric grains is increased, thereby improving ferroelectricity of the memory.

In a possible implementation of the sixth aspect, forming the first isolation passivation layer and/or the second isolation passivation layer includes: The first isolation passivation layer is obtained by using a thin film deposition method.

In this way, a process method for manufacturing the first isolation passivation layer and the second isolation passivation layer can be compatible with a process of manufacturing another layer structure in the ferroelectric memory, so that a case in which manufacturing costs are increased because the isolation passivation layer structure needs to be added can be avoided. For example, a deposition process such as physical vapor deposition, chemical vapor deposition, and atomic layer deposition may be used.

In a possible implementation of the sixth aspect, forming the first isolation passivation layer and/or the second isolation passivation layer includes: The first isolation passivation layer is made of a metal material having chemical inertia. Chemical inertia of the first isolation passivation layer is greater than both chemical inertia of the ferroelectric layer and chemical inertia of the channel area. Chemical inertia of the second isolation passivation layer is greater than both the chemical inertia of the ferroelectric layer and chemical inertia of the gate.

In a possible implementation of the sixth aspect, forming the first isolation passivation layer and/or the second isolation passivation layer includes: The first isolation passivation layer is made of at least one of metal oxide and a metal. For example, a metal such as titanium oxide (TiO₂), tungsten oxide (WO₃), tantalum oxide (TazOs), niobium oxide (Nb₂O₅), aluminum oxide (Al₂O₃), magnesium oxide (MgO), or cerium oxide (CeO₂), platinum (Pt), or palladium (Pd) may be used.

In a possible implementation of the sixth aspect, a thickness of the first isolation passivation layer and/or a thickness of the second isolation passivation layer in a stacking direction of the ferroelectric layer and the gate are/is 0.5 nm to 5 nm.

In a possible implementation of the sixth aspect, forming the first isolation passivation layer and the second isolation passivation layer includes: The first isolation passivation layer and the second isolation passivation layer are made of an amorphous material.

According to a seventh aspect, this application further provides an electronic device. The electronic device includes a processor and the ferroelectric memory in any one of the implementations of the first aspect, the second aspect, the third aspect, the fourth aspect, the fifth aspect, or the sixth aspect. The processor is electrically connected to the ferroelectric memory.

The electronic device provided in embodiments of this application includes the ferroelectric memory in the embodiment of the first aspect, the embodiment of the second aspect, the embodiment of the third aspect, the embodiment of the fourth aspect, the embodiment of the fifth aspect, or the embodiment of the sixth aspect. Therefore, the electronic device provided in embodiments of this application and the ferroelectric memory in the foregoing technical solutions may resolve a same technical problem, and achieve a same expected effect.

### BRIEF DESCRIPTION OF DRAWINGS

FIG. 1 is a diagram of a process structure of a ferroelectric capacitor of a FeRAM in the conventional technology;
FIG. 2 is an enlarged diagram of an interface A between a first electrode and a ferroelectric layer of a ferroelectric capacitor of a FeRAM in the conventional technology;
FIG. 3 is a diagram of a process structure of a ferroelectric capacitor having dead layers in the conventional technology;
FIG. 4 is a curve diagram of ferroelectric performance of a ferroelectric capacitor having a dead layer in the conventional technology;
FIG. 5 is a comparison diagram of polarization state distribution curves when a ferroelectric capacitor has a dead layer and when the ferroelectric capacitor has no dead layer in the conventional technology;
FIG. 6 is a circuit diagram of an electronic device according to an embodiment of this application;
FIG. 7 is a circuit diagram of a ferroelectric memory according to an embodiment of this application;
FIG. 8 is a circuit diagram of a memory cell of a ferroelectric memory according to an embodiment of this application;
FIG. 9 is a circuit diagram of a memory array including a plurality of memory cells of a ferroelectric memory according to an embodiment of this application;
FIG. 10 is a circuit diagram of a memory cell of a ferroelectric memory according to an embodiment of this application;
FIG. 11 is a circuit diagram of a memory array including a plurality of memory cells of a ferroelectric memory according to an embodiment of this application;
FIG. 12 is a diagram of a process structure of a ferroelectric capacitor of a memory cell of a ferroelectric memory according to an embodiment of this application;
FIG. 13 is a schematic diagram of a location relationship between a ferroelectric capacitor and a substrate in a ferroelectric memory according to an embodiment of this application;
FIG. 14 is a schematic diagram of a location relationship between a ferroelectric capacitor and a substrate in a ferroelectric memory according to an embodiment of this application;
FIG. 15 is a B-direction view of FIG. 14;
FIG. 16 is a block diagram of a procedure of manufacturing a ferroelectric capacitor in a ferroelectric memory according to an embodiment of this application;
FIG. 17 is a diagram of a process structure of a memory cell of a ferroelectric memory according to an embodiment of this application;
FIG. 18 is a circuit diagram of a memory array including a plurality of memory cells of a ferroelectric memory according to an embodiment of this application; and
FIG. 19 is a block diagram of a procedure of manufacturing a memory cell in a ferroelectric memory according to an embodiment of this application.

### Reference numerals:

01-First electrode; 02-Second electrode; 03-Ferroelectric layer; 04-First isolation passivation layer; 05-Second isolation passivation layer; 06-Dead layer; 07-Gate;
100-Substrate; 100a-First doped area; 100b-Second doped area; and 100c-Channel area.

### DESCRIPTION OF EMBODIMENTS

Before embodiments in this application are described, technical terms in this application are first described. Details are as follows:
Amorphous solid: The amorphous solid is a material that has an irregular shape and an unfixed melting point, has an internal structure without a long-range order, and has a structure with an order arrangement within a short range of several interatomic distances. In other words, the amorphous solid is a material whose internal particles are not periodically and repeatedly arranged in three-dimensional space, and has a short-range order rather than the long-range order.

Crystal: The crystal is a structure including a large quantity of micro-material units (such as atoms, ions, and molecules) that are arranged in order according to a specific rule. Therefore, an arrangement rule and a crystal form may be determined based on a size of a structure unit. In other words, the crystal is a material whose internal particles are periodically and repeatedly arranged in three-dimensional space.

Crystalline orientation: The crystalline orientation usually refers to directivity of covalent crystals. To be specific, covalent bonds are formed in a specific direction. Based on a quantum theory of the covalent bonds, strength of the covalent bonds depends on a degree of overlapping of electron clouds. Due to asymmetrical distribution of electrons at an unfilled shell, the bonds are always formed in a direction with highest density of electron clouds. For example, forms of the crystalline orientation include a monoclinic crystalline phase, a tetragonal crystalline phase, an orthorhombic crystalline phase, and the like. The orthorhombic crystalline phase may further include [001], [100], and [010].

Crystallization temperature: At a specific temperature, atoms are rearranged to reduce chemical potential and the atoms convert to stable crystals. This process is referred to as crystallization, and the temperature during crystallization is referred to as the crystallization temperature.

A ferroelectric memory stores data based on a ferroelectric effect of a ferroelectric material. The ferroelectric memory is expected to be a main competitor for replacing a DRAM because the ferroelectric memory has advantages such as ultra-high storage density, low power consumption, and a high speed. A memory cell in the ferroelectric memory includes a ferroelectric capacitor, and the ferroelectric capacitor includes two electrodes and a ferroelectric material disposed between the two electrodes, for example, a ferroelectric film layer. Due to a non-linear characteristic of the ferroelectric material, a dielectric constant of the ferroelectric material can be adjusted, and a difference between dielectric constants obtained before and after a polarization state of the ferroelectric layer is reversed is excessively large. Therefore, the ferroelectric capacitor has a smaller size than another capacitor. For example, the size of the ferroelectric capacitor is much smaller than that of a capacitor configured to store a charge in the DRAM.

In the ferroelectric memory, the ferroelectric layer may be formed by using a common ferroelectric material. When an electric field is applied to the ferroelectric layer of the memory cell, a central atom stays in a low-energy state in a direction of the electric field. On the contrary, when an inverse electric field is applied to the ferroelectric layer, the central atom moves in a crystal in a direction of the electric field and stays in another low-energy state. A large quantity of central atoms move and are coupled in a unit cell of the crystal to form a ferroelectric domain (ferroelectric domain), and the ferroelectric domain forms a polarization charge under the action of the electric field. The ferroelectric domain forms a high polarization charge during electric field inversion, and forms a low polarization charge without electric field inversion. Due to a binary stable state of the ferroelectric material, the ferroelectric material may be used as memory.

Embodiments of this application provide an electronic device including a ferroelectric memory. FIG. 6 shows an electronic device 200 according to an embodiment of this application. The electronic device 200 may be a terminal device, for example, a mobile phone, a tablet computer, or a smart band, or may be a personal computer (personal computer, PC), a server, a workstation, or the like. The electronic device 200 includes a bus 205, and a system on chip (system on chip, SoC) 210 and a read-only memory (read-only memory, ROM) 220 that are connected to the bus 205. The SoC 210 may be configured to process data, for example, process data of an application program, process image data, and cache temporary data. The ROM 220 may be configured to store non-volatile data, for example, an audio file or a video file. The ROM 220 may be a PROM (programmable read-only memory, programmable read-only memory), an EPROM (erasable programmable read-only memory, erasable programmable read-only memory), a flash memory (flash memory), or the like.

In addition, the electronic device 200 may further include a communication chip 230 and a power management chip 240. The communication chip 230 may be configured to process a protocol stack, or perform processing such as amplification and filtering on an analog radio frequency signal, or implement the foregoing functions at the same time. The power management chip 240 may be configured to supply power to another chip.

In an implementation, the SoC 210 may include an application processor (application processor, AP) 211 configured to process the application program, a graphics processing unit (graphics processing unit, GPU) 212 configured to process the image data, and a random access memory (random access memory, RAM) 213 configured to cache data.

The foregoing AP 211, GPU 212, and RAM 213 may be integrated into one die (die), or may be respectively integrated into a plurality of dies (dies), and are packaged in a packaging structure by using 2.5D (dimension) or 3D packaging, another advanced packaging technology, or the like. In an implementation, the foregoing AP 211 and GPU 212 are integrated into one die, the RAM 213 is integrated into another die, and the two dies are packaged in a packaging structure, to obtain a faster inter-die data transmission rate and a higher data transmission bandwidth.

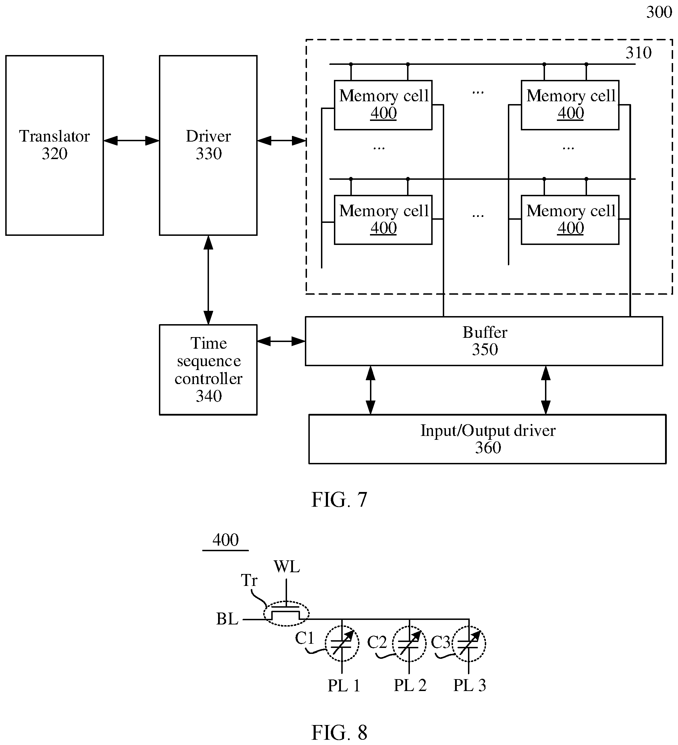

FIG. 7 is a schematic diagram of a structure of a ferroelectric memory 300 according to an embodiment of this application. The ferroelectric memory 300 may be the RAM 213 shown in FIG. 6, and belongs to a FeRAM. In an implementation, the ferroelectric memory 300 may alternatively be a RAM disposed outside an SoC 210. A location of the ferroelectric memory 300 in a device and a location relationship between the ferroelectric memory 300 and the SoC 210 are not limited in this application.

Still refer to FIG. 7. The ferroelectric memory 300 includes a memory array 310, a translator 320, a driver 330, a time sequence controller 340, a buffer 350, and an input/output driver 360. The memory array 310 includes a plurality of memory cells 400 arranged in an array. Each memory cell 400 may be configured to store one-bit or multi-bit data. The memory array 310 further includes signal lines, for example, a word line (word line, WL) and a bit line (bit line, BL). Each memory cell 400 is electrically connected to a corresponding word line WL and a corresponding bit line BL. One or more of the word line WL and the bit line BL are configured to select, by receiving a control level output by a control circuit, a to-be-read/written memory cell 400 in the memory array, to change a polarization direction of a ferroelectric capacitor in the memory cell 400, so as to implement a data read/write operation.

In the structure of the ferroelectric memory 300 shown in FIG. 7, the translator 320 is configured to perform translation based on a received address, to determine a memory cell 400 that needs to be accessed. The driver 330 is configured to control a level of the signal line based on a translation result generated by the translator 320, to access to the specified memory cell 400. The buffer 350 is configured to cache read data, for example, may cache the data in a first-in first-out (first-in first-out, FIFO) manner. The time sequence controller 340 is configured to: control a time sequence of the buffer 350, and control the driver 330 to drive the signal line in the memory array 310. The input/output driver 360 is configured to drive a transmission signal, for example, drive a received data signal and drive a data signal that needs to be sent, so that the data signals can be communicated over a long distance.

The foregoing memory array 310, translator 320, driver 330, time sequence controller 340, buffer 350, and input/output driver 360 may be integrated into one chip, or may be respectively integrated into a plurality of chips.

The ferroelectric memory 300 in this application may be a ferroelectric random access memory (ferroelectric random access memory, FeRAM), or may be a ferroelectric field-effect transistor (ferroelectric field-effect transistor, FeFET) memory. For example, FIG. 8 is a diagram of a circuit structure of a memory cell 400 of a FeRAM. As shown in FIG. 8, the memory cell 400 includes at least two ferroelectric capacitors C and one transistor Tr. For example, FIG. 8 shows three ferroelectric capacitors (for example, a ferroelectric capacitor C1, a ferroelectric capacitor C2, and a ferroelectric capacitor C3 in FIG. 8). The memory cell may be referred to as a 1TnC memory cell. The transistor Tr herein may be a metal-oxide-semiconductor field-effect transistor (metal-oxide-semiconductor field-effect transistor, MOSFET).

In addition, the memory cell 400 further includes a word line (word line, WL), a bit line (bit line, BL), and a plate line (plate line, PL), and in the memory cell 400, a first end of the transistor Tr is electrically connected to the bit line BL, a control end of the transistor Tr is electrically connected to the word line WL, a second end of the transistor Tr is electrically connected to a first electrode of the ferroelectric capacitor C, and a second electrode of the ferroelectric capacitor C is electrically connected to the plate line PL.

In this application, one of a drain (drain) and a source (source) of the transistor Tr is referred to as the first end, the other one is correspondingly referred to as the second end, and the control end of the transistor Tr is a gate. The drain and the source of the transistor Tr may be determined based on a flow direction of a current. For example, in FIG. 8, when the current flows from left to right, a left end is the drain, and a right end is the source. On the contrary, when the current flows from right to left, the right end is the drain, and the left end is the source.

It may be understood that the transistor Tr herein is a transistor device having three terminals. Therefore, the transistor Tr may be an NMOS (N-channel metal oxide semiconductor, N-channel metal oxide semiconductor) transistor, or may be a PMOS (P-channel metal oxide semiconductor, P-channel metal oxide semiconductor) transistor.

The memory cell 400 shown in FIG. 8 may be configured to store multi-bit data, to increase a storage capacity of each memory cell. In particular, these ferroelectric capacitors C share one transistor Tr, so that a quantity of transistors of each memory cell 400 can be reduced, thereby increasing storage density.

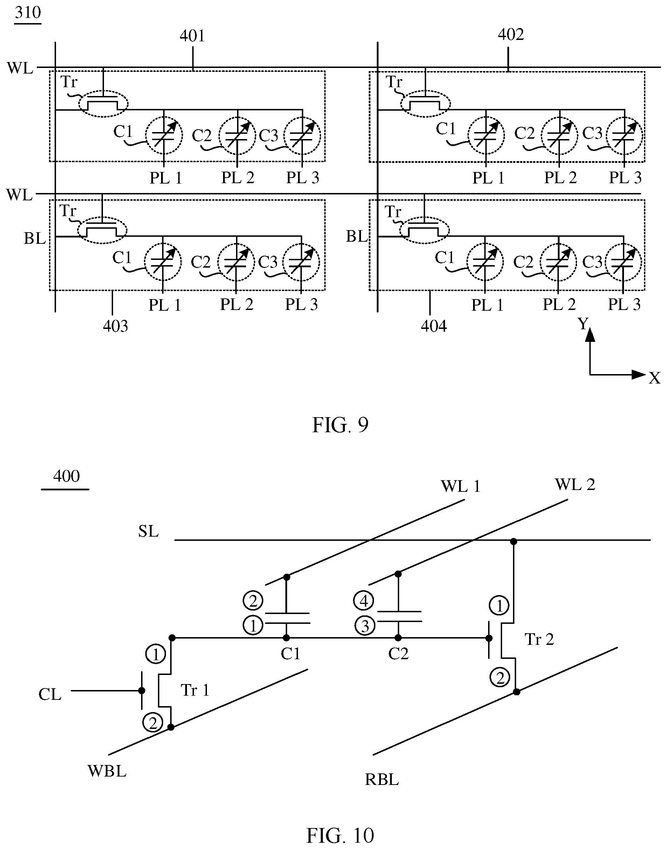

A memory array 310 may be obtained by arranging memory cells 400 shown in FIG. 8 in an array. Each memory cell 400 has a same circuit structure. For example, in a memory array 310 shown in FIG. 9, the memory array includes four memory cells: a memory cell 401, a memory cell 402, a memory cell 403, and a memory cell 404. A person skilled in the art may design an arrangement manner of the memory cells 400 in the memory array 310 and a quantity of memory cells 400 based on a storage capacity requirement of a ferroelectric memory. In an implementation, the memory array 310 may further include more memory cells 400, and these memory cells 400 may be arranged in an X direction, a Y direction, and a Z direction that are perpendicular to each other, to form a three-dimensional memory array.

In an optional implementation, in the memory array 310 shown in FIG. 9, a word line WL extends in the X direction, so that control ends of transistors Tr of a plurality of memory cells arranged in the X direction are electrically connected to the same word line WL. In addition, a bit line BL extends in the Y direction perpendicular to the X direction. In this way, first ends of transistors Tr of a plurality of memory cells arranged in the Y direction are electrically connected to the same bit line BL.

FIG. 10 is a diagram of a circuit structure of another memory cell 400 of a FeRAM. The memory cell 400 includes a first transistor Tr 1, a second transistor Tr 2, and at least two ferroelectric capacitors. For example, FIG. 10 shows that one memory cell 400 includes two ferroelectric capacitors: a ferroelectric capacitor C1 and a ferroelectric capacitor C2. The ferroelectric capacitor C2 and the ferroelectric capacitor C1 have a same structure, and both include two electrodes and a ferroelectric layer located between the two electrodes. For ease of clearly describing an electrical connection relationship between the ferroelectric capacitor C2 and the ferroelectric capacitor C1 and another structure in the following, one electrode of the ferroelectric capacitor C 1 may be referred to as a first electrode, the other electrode may be referred to as a second electrode, one electrode of the ferroelectric capacitor C2 may be referred to as a third electrode, and the other electrode may be referred to as a fourth electrode.

With reference to FIG. 10 again, the memory cell 400 further includes word lines (word lines, WLs), a write bit line (write bit line, WBL), a read bit line (read bit line, RBL), a source line (source line, SL), and a control line (control line, CL). A control end of the first transistor Tr 1 is electrically connected to the control line CL, a first end of the first transistor Tr 1 is electrically connected to the first electrode of the ferroelectric capacitor C1 and the third electrode of the ferroelectric capacitor C2, a second end of the first transistor Tr 1 is electrically connected to the write bit line WBL, and the second electrode of the ferroelectric capacitor C1 and the fourth electrode of the ferroelectric capacitor C2 are electrically connected to the corresponding word lines WLs.

Still refer to FIG. 10. A first end of the second transistor Tr 2 is electrically connected to the source line SL, a second end is electrically connected to the read bit line RBL, and a control end of the second transistor T2 is electrically connected to the first electrode of the ferroelectric capacitor C1 and the third electrode of the ferroelectric capacitor C2.

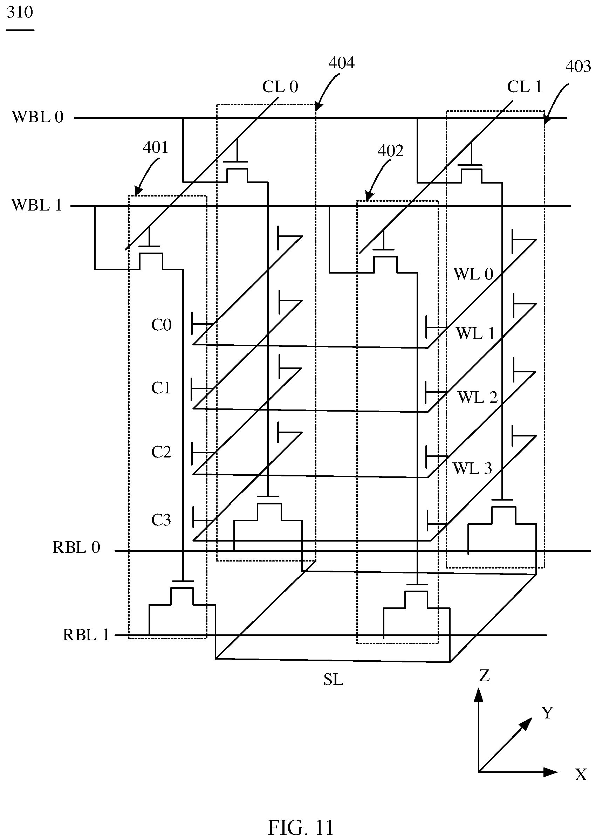

In an optional implementation, a memory array 310 shown in FIG. 11 may be obtained by arranging memory cells 400 shown in FIG. 10 in an array. For example, in the memory array 310 shown in FIG. 11, the memory array includes four memory cells: a memory cell 401, a memory cell 402, a memory cell 403, and a memory cell 404.

The memory array 310 shown in FIG. 11 includes two control lines: a control line CL 0 and a control line CL 1, and each control line extends in a Y direction. When the memory array 310 further includes more memory cells, the memory array 310 further correspondingly includes more control lines CLs. These control lines are arranged in parallel in an X direction perpendicular to the Y direction. In addition, a plurality of memory cells arranged in the Y direction may share one control line. For example, the memory cell 401 and the memory cell 404 share the control line CL 0, and the memory cell 402 and the memory cell 403 share the control line CL 1.

Still with reference to FIG. 11, the memory array 310 includes two write bit lines: a write bit line WBL 0 and a write bit line WBL 1, and each write bit line extends in the X direction. When more write bit lines WBLs are further included, these write bit lines WBLs are arranged in parallel in the Y direction perpendicular to the X direction. In addition, a plurality of memory cells arranged in the X direction may share one write bit line WBL. For example, the memory cell 401 and the memory cell 402 share the write bit line WBL 1, and the memory cell 403 and the memory cell 404 share the write bit line WBL 0.

Similarly, a manner of disposing read bit lines RBLs is the same as a manner of disposing the write bit lines WBLs. Details are not described herein again.

It should be noted that, for a source line SL in the memory array, not only the plurality of memory cells arranged in the X direction share the source line SL, but also the plurality of memory cells arranged in the Y direction share the source line SL. For example, herein, the memory cell 401 and the memory cell 404 share the source line SL, and the memory cell 401 and the memory cell 402 also share the source line SL. That is, the memory cell 401, the memory cell 402, the memory cell 403, and the memory cell 404 herein are connected to each other through the source line. In an implementable process structure, a source line SL layer structure parallel to a substrate may be formed, to electrically connect source lines parallel to the substrate.

In addition, it should be noted that, for a word line WL in the memory array, not only the plurality of memory cells arranged in the X direction share the word line WL, but also the plurality of memory cells arranged in the Y direction share the word line WL. For example, herein, a ferroelectric capacitor C0 of the memory cell 401 and a ferroelectric capacitor C0 of the memory cell 402 share a word line WL 0, the ferroelectric capacitor C0 of the memory cell 401 and a ferroelectric capacitor C0 of the memory cell 404 share the word line WL 0. That is, herein, four ferroelectric capacitors C0 of the memory cell 401, the memory cell 402, the memory cell 403, and the memory cell 404 are connected to each other through the word line WL 0, and four ferroelectric capacitors C1 of the memory cell 401, the memory cell 402, and the memory cell 403, and the memory cell 404 are connected to each other through a word line WL 1. Similarly, in an implementable process structure, a word line layer structure parallel to the substrate may be disposed, to connect word lines located at a same layer.

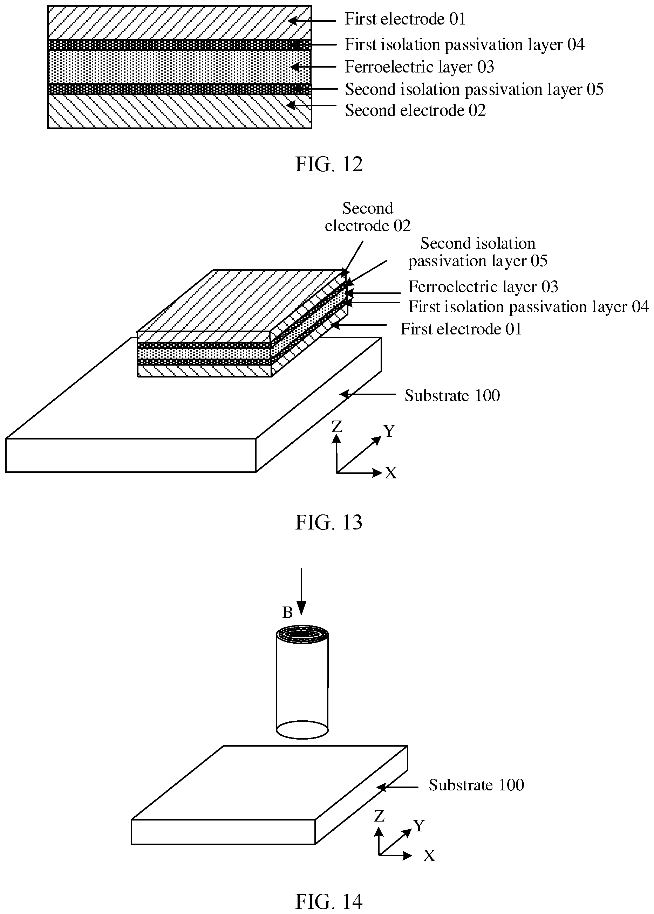

In the foregoing memory cell 400 of the FeRAM shown in FIG. 8, FIG. 9, FIG. 10, and FIG. 11, as shown in FIG. 12, a ferroelectric capacitor structure may not only include a first electrode 01 and a second electrode 02 that are stacked, and a ferroelectric layer 03 formed between the first electrode 01 and the second electrode 02, but also include a first isolation passivation layer 04 and a second isolation passivation layer 05. In addition, the first isolation passivation layer 04 is formed between the first electrode 01 and the ferroelectric layer 03, and the second isolation passivation layer 05 is formed between the second electrode 02 and the ferroelectric layer 03.

In some optional implementations, the ferroelectric layer 03 is made of a hafnium oxide based material. Compared with another ferroelectric material, a thickness of a hafnium oxide based ferroelectric capacitor may be miniaturized to 10 nanometers or even 1 to 10 nanometers. In this way, high-density integration or even three-dimensional integration can be implemented, and a large advantage is achieved in constructing an ultra-high-density memory chip. In addition, a manufacturing process of the hafnium oxide based ferroelectric capacitor may be well compatible with a silicon-based semiconductor process. In this way, the ferroelectric capacitor can be manufactured by using a mature manufacturing process without increasing manufacturing costs.

The hafnium oxide based material in this application is a ferroelectric material based on a hafnium oxide material system, for example, may be hafnium oxide (HfO₂) doped with silicon (Si), HfO₂ doped with aluminum (Al), HfO₂ doped with lanthanum (La), HfO₂ doped with yttrium (Y), HfOz doped with gadolinium (Gd), or HfO₂ doped with strontium (Sr). Alternatively, the hafnium oxide based material may be based on a hafnium zirconium oxide (hafnium zirconium oxide, HZO) system, for example, may be HZO doped with lanthanum (La), HZO doped with yttrium (Y), HZO doped with strontium (Sr), HZO doped with gadolinium (Gd), or HZO doped with gadolinium and lanthanum (Gd/La).

In some implementations, metals may be selected as materials of the first electrode 01 and the second electrode 02. For example, following metals may be selected, but these metal materials do not constitute a limitation. For example, titanium nitride (TiN), tantalum nitride (TaN), zirconium nitride (ZrN), tungsten nitride (WN), silicon titanium nitride (TiSiN), titanium carbon nitride (TiCN), tungsten (W), ruthenium (Ru), molybdenum (Mo), iridium (Ir), nickel (Ni), platinum (Pt), ruthenium oxide (RuO), iridium oxide (IrO), and indium tin oxide (ITO) may be selected. In addition, the materials of the first electrode 01 and the second electrode 02 may be the same, or may be different. When the first electrode 01 and the second electrode 02 are made of the foregoing metals, the formed ferroelectric capacitor structure shown in FIG. 12 may be referred to as a metal-isolation passivation-ferroelectric-isolation passivation-metal (metal-passivation-ferroelectric-passivation-metal, MPFPM) ferroelectric capacitor structure.

In some designs, thicknesses of the first electrode 01 and the second electrode 02 in a stacking direction may be but are not limited to 1 nm to 100 nm. In addition, the thickness of the first electrode 01 may be equal to or not equal to the thickness of the second electrode 02.

In some scenarios, the first electrode 01 and the second electrode 02 may be made of titanium nitride TiN, and the ferroelectric layer 03 may be made of HZO. Because an HZO layer provides a tensile stress that helps form a ferroelectric phase, and the TiN material may be compatible with a semiconductor CMOS process.

In addition, a thickness of the ferroelectric layer 03 in the stacking direction may be but is not limited to 1 nm to 100 nm.

As shown in FIG. 12, the first isolation passivation layer 04 disposed between the first electrode 01 and the ferroelectric layer 03 can suppress diffusion of an oxygen element in the ferroelectric layer 03 to the first electrode 01. In other words, the first isolation passivation layer 04 herein can isolate the first electrode 01 from the ferroelectric layer 03 and passivate the ferroelectric layer 03. For example, when the first electrode 01 can be made of titanium nitride TiN, and the ferroelectric layer 03 can be made of hafnium oxide HfOz, the first isolation passivation layer 04 is disposed, so that TiN in the first electrode 01 does not obtain the oxygen element in HfO₂ in the ferroelectric layer 03 to generate TiOxNy, and HfO₂ does not generate HfO₍₂₋ₓ₎ due to a loss of the oxygen element. That is, a structure of a dead layer 06 shown in FIG. 3 is not formed between the first electrode 01 and the ferroelectric layer 03. Therefore, the first isolation passivation layer 04 is disposed, so that the structure of the dead layer that cannot present the ferroelectric phase cannot be formed. In addition, a deficiency of the oxygen element does not occur at the ferroelectric layer 03, and a phenomenon of a leakage channel does not occur inside the ferroelectric layer. Therefore, a phenomenon that the ferroelectric capacitor is broken down can be avoided.

Similarly, the second isolation passivation layer 05 disposed between the second electrode 02 and the ferroelectric layer 03 can suppress diffusion of the oxygen element in the ferroelectric layer 03 to the second electrode 02, so that the structure of the dead layer that cannot present the ferroelectric phase is not formed between the second electrode 02 and the ferroelectric layer 03, and a case in which the ferroelectric capacitor is broken down due to the deficiency of the oxygen element in the ferroelectric layer 03 is avoided. Therefore, durability of the memory may be improved.

A suppression effect of the first isolation passivation layer 04 in this application may be understood as follows: In some embodiments, the first isolation passivation layer 04 may completely prevent the oxygen element in the ferroelectric layer 03 from diffusing to the first electrode 01. In some other embodiments, a small quantity of oxygen elements in the ferroelectric layer 03 may diffuse to the first electrode 01 through the first isolation passivation layer 04. However, the quantity of diffused oxygen elements is small. In this way, basically, the phenomenon of the leakage channel does not occur in the ferroelectric layer, and the structure of the dead layer in a non-ferroelectric phase is not formed.

For descriptions of a suppression effect of the second isolation passivation layer 05 in this application, refer to the suppression effect of the first isolation passivation layer 04. Details are not described herein again.

In some implementations, the first isolation passivation layer 04 may include a metal material having chemical inertia.

It should be explained that the metal material herein is a compound (for example, metal oxide) including a metal, a metal simple substance, or the like.

In addition, to enable the first isolation passivation layer 04 having chemical inertia to suppress the diffusion of the oxygen element in the ferroelectric layer 03, and to prevent an element (for example, an oxygen element) in the first isolation passivation layer 04 from diffusing to the first electrode 01 due to introduction of the first isolation passivation layer 04, the chemical inertia of the first isolation passivation layer 04 needs to be not only greater than chemical inertia of the ferroelectric layer 03, but also greater than chemical inertia the first electrode 01. For example, when the first isolation passivation layer 04 herein is made of titanium oxide (TiO₂) with high chemical stability, titanium oxide (TiO₂) is not combined with the oxygen element in a hafnium oxide based material in the ferroelectric layer 03, and an oxygen element in titanium oxide (TiO₂) is not combined with the metal material in the first electrode 01. In this way, both ferroelectric performance of the ferroelectric layer and conductive performance of the first electrode 01 can be ensured.

The chemical inertia in this application means that a metal material such as a compound including a metal or a metal simple substance is basically inactive, basically does not react to a chemical substance in an adjacent layer structure, and is in a chemically stable state. For example, that the chemical inertia of the first isolation passivation layer 04 is greater than the chemical inertia of the ferroelectric layer 03 means that the first isolation passivation layer 04 made of the metal material does not obtain the oxygen element in the ferroelectric layer 03, and the hafnium oxide based material in the ferroelectric layer 03 does not obtain the metal material from the isolation passivation layer made of the metal material. For another example, that the chemical inertia of the first isolation passivation layer 04 is greater than the chemical inertia of the first electrode 01 means that the first electrode 01 cannot obtain oxygen from the first isolation passivation layer 04 made of the metal material, and the hafnium oxide based material in the ferroelectric layer 03 does not obtain the metal material from the first electrode 01.

The first isolation passivation layer 04 having chemical inertia has a plurality of optional materials. For example, the first isolation passivation layer 04 includes at least one of metal oxide and a metal. For example, at least one of metal oxide such as titanium oxide (TiO₂), tungsten oxide (WO₃), tantalum oxide (Ta₂O₅), niobium oxide (NbzOs), aluminum oxide (Al₂O₃), magnesium oxide (MgO), and cerium oxide (CeO₂), or at least one of metals such as platinum (Pt) and palladium (Pd) may be selected.

During design, a thickness of the first isolation passivation layer 04 in a stacking direction of structures of the ferroelectric capacitor may be selected as 0.5 nm to 5 nm. In other words, formation of the dead layer and formation of the leakage channel in the ferroelectric layer 03 are suppressed by controlling the thickness of the first isolation passivation layer 04.

The foregoing metal materials having chemical inertia may be of an amorphous structure, or may be of a crystal structure.

Because the ferroelectric layer 03 includes the hafnium oxide based material, when the ferroelectric layer 03 is of an orthorhombic crystalline phase crystal structure, the ferroelectric layer 03 may represent good ferroelectricity. In this case, to enable the ferroelectric layer 03 to present an orthorhombic crystalline phase, in some implementation procedures, the first isolation passivation layer 04 may be made of an amorphous material, for example, may select at least one of amorphous materials such as titanium oxide (TiO₂), tungsten oxide (WO₃), and aluminum oxide (Al₂O₃). In this way, the ferroelectric layer 03 grows on a template of the amorphous structure. An atom arrangement and a crystalline orientation of the ferroelectric layer 03 are not affected by the material of the first electrode 01, so that a phenomenon that the crystalline orientation of the ferroelectric layer 03 is consistent with a crystalline orientation of the first electrode 01, and therefore, an orientation cannot be preferably selected does not occur. On the contrary, an orthorhombic crystalline phase with good ferroelectric performance is preferably selected on the template of the first isolation passivation layer 04 of the amorphous structure, so that the ferroelectric layer 03 that presents the orthorhombic crystalline phase can further improve storage performance of the ferroelectric capacitor.

In addition, because the first isolation passivation layer 04 made of the amorphous material exists between the first electrode 01 and the ferroelectric layer 03, even if the first electrode 01 is made of a different material, an initial growing environment of the ferroelectric layer 03 is not affected, and a phenomenon of inconsistent grain sizes due to the different material of the first electrode 01 does not occur at the ferroelectric layer 03. Therefore, although the first electrode 01 is made of a different material, the grain sizes of the ferroelectric layer 03 are consistent, and the crystalline orientation of the ferroelectric layer is also basically consistent.

In some implementations, for example, when the first isolation passivation layer 04 is made of amorphous titanium oxide (TiO₂), a crystallization temperature of titanium oxide (TiO₂) is greater than a maximum process temperature for forming a ferroelectric capacitor. In this case, after the ferroelectric capacitor is obtained by using a process such as annealing, the first isolation passivation layer 04 still exists in a form of the amorphous structure. In other words, after the process of manufacturing the ferroelectric capacitor is completed, the first isolation passivation layer 04 still includes the amorphous structure. In this way, in this embodiment, an amorphous structure of titanium oxide (TiO₂) is used to suppress impact of the first electrode 01 on the crystalline orientation of the ferroelectric layer 03, so that the ferroelectric layer 03 made of the hafnium oxide based material implements the orthorhombic crystalline phase.

In some other implementations, for example, when the first isolation passivation layer 04 is made of amorphous aluminum oxide (Al₂O₃), after a ferroelectric capacitor is obtained by using a process such as annealing, the first isolation passivation layer 04 is partially crystallized, so that the first isolation passivation layer 04 includes both the amorphous structure and an orthorhombic crystalline phase structure. In this case, in this embodiment, the impact of the first electrode 01 on the crystalline orientation of the ferroelectric layer 03 is suppressed by using the amorphous structure of these materials. In addition, a crystal structure of the orthorhombic crystalline phase can better assist the ferroelectric layer 03 made of the hafnium oxide based material in preferably selecting an orientation, to implement the orthorhombic crystalline phase.

In some other implementations, for example, when the first isolation passivation layer 04 is made of amorphous tungsten oxide (WO₃), a crystallization temperature of tungsten oxide (WO₃) is less than a maximum process temperature for forming a ferroelectric capacitor. In this case, after the ferroelectric capacitor is obtained by using a process such as annealing, the first isolation passivation layer 04 is crystallized, so that the first isolation passivation layer 04 includes a crystal structure of the orthorhombic crystalline phase. Therefore, in this embodiment, the orthorhombic crystalline phase of tungsten oxide (WO₃) can be used to assist the ferroelectric layer 03 made of the hafnium oxide based material in preferably selecting an orientation, to implement the orthorhombic crystalline phase.

In conclusion, when the first isolation passivation layer 04 includes at least one of the amorphous structure and the orthorhombic crystalline phase, the impact of the first electrode 01 on the crystalline orientation of the ferroelectric layer 03 can be suppressed, so that the ferroelectric layer 03 grows towards the orthorhombic crystalline phase.

The foregoing describes the material, the thickness, chemical inertia strength, and the like that may be selected for the first isolation passivation layer 04 located between the ferroelectric layer 03 and the first electrode 01. For a material, thickness, and chemical strength of the second isolation passivation layer 05 located between the second electrode 02 and the ferroelectric layer 03, refer to the foregoing first isolation passivation layer 04. Details are not described herein again.

In the ferroelectric capacitor shown in FIG. 12 in this application, a manner of disposing the first electrode 01, the second electrode 02, the ferroelectric layer 03, the first isolation passivation layer 04, and the second isolation passivation layer 05 on a substrate 100 may be shown in FIG. 13. To be specific, the first electrode 01, the first isolation passivation layer 04, the ferroelectric layer 03, the second isolation passivation layer 05, and the second electrode 02 are stacked in a direction perpendicular to the substrate 100. In other words, each layer structure of the first electrode 01, the first isolation passivation layer 04, the ferroelectric layer 03, the second isolation passivation layer 05, and the second electrode 02 is arranged in a direction parallel to the substrate 100. The ferroelectric capacitor may be referred to as a planar ferroelectric capacitor structure.

In some other implementations, a manner of disposing the first electrode 01, the second electrode 02, the ferroelectric layer 03, the first isolation passivation layer 04, and the second isolation passivation layer 05 on a substrate 100 may be shown in FIG. 14. To be specific, the first electrode 01, the first isolation passivation layer 04, the ferroelectric layer 03, the second isolation passivation layer 05, and the second electrode 02 are stacked in a direction parallel to the substrate 100. The ferroelectric capacitor may be referred to as a vertical capacitor structure. When the vertical capacitor structure is used, three-dimensional stacking can be implemented, thereby increasing storage density and a storage capacity.

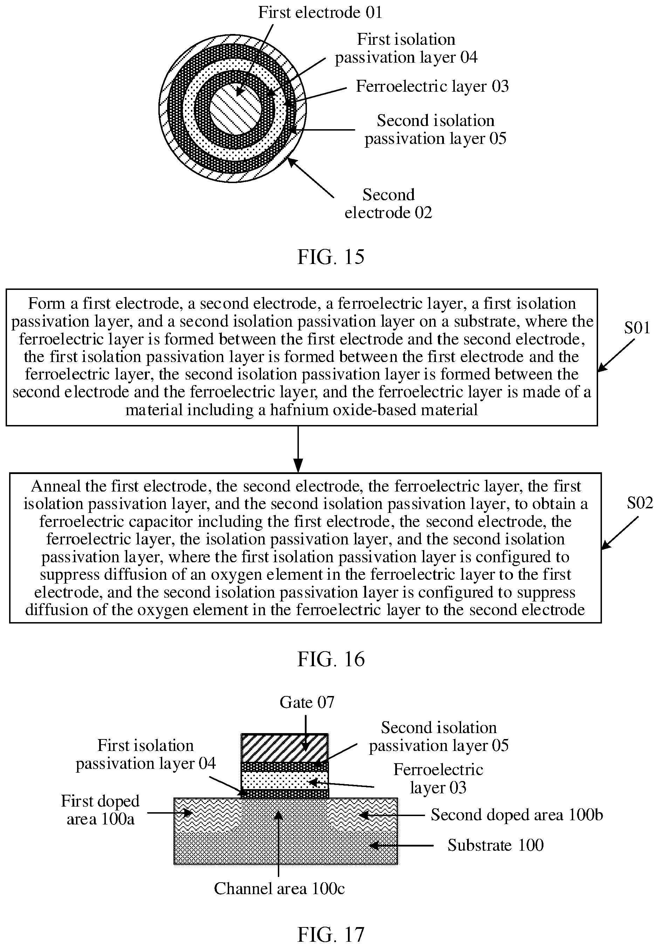

FIG. 14 shows an implementable structure of a vertical ferroelectric capacitor structure, and FIG. 15 is a B-direction view of FIG. 14. Specifically, a first electrode 01 extends in a direction perpendicular to a substrate 100, and a first isolation passivation layer 04, a ferroelectric layer 03, a second isolation passivation layer 05, and a second electrode 02 sequentially surround the periphery of the first electrode 01 in a direction parallel to the substrate 100. In this way, a ferroelectric capacitor of a column structure is formed. In addition, a cross section of the ferroelectric capacitor of the column structure may be a circle shown in FIG. 15, or may be a rectangle, or may be another shape.

This application further provides a method for forming the ferroelectric capacitor shown in FIG. 12. FIG. 16 is an implementable flowchart of the forming method. Specific steps are as follows.

Step S01: Form a first electrode, a second electrode, a ferroelectric layer, a first isolation passivation layer, and a second isolation passivation layer on a substrate, where the ferroelectric layer is formed between the first electrode and the second electrode, the first isolation passivation layer is formed between the first electrode and the ferroelectric layer, the second isolation passivation layer is formed between the second electrode and the ferroelectric layer, and the ferroelectric layer is made of a material including a hafnium oxide based material.

For example, when a planar ferroelectric capacitor structure is manufactured on the substrate, the first electrode, the first isolation passivation layer, the ferroelectric layer, the second isolation passivation layer, and the second electrode may be sequentially manufactured in a direction perpendicular to the substrate.

In a process, for optional materials of the first electrode, the first isolation passivation layer, the ferroelectric layer, the second isolation passivation layer, and the second electrode, refer to the related descriptions of the materials selected for the layer structures in the descriptions of the structure shown in FIG. 12.

When the first electrode, the second electrode, or the ferroelectric layer is formed, a magnetron sputtering deposition method may be used, or a thin film deposition method may be used, for example, a deposition process such as chemical vapor deposition (chemical vapor deposition, CVD), physical vapor deposition (physical vapor deposition, PVD), or atomic layer deposition (atomic layer deposition, ALD).

When the first isolation passivation layer or the second isolation passivation layer is formed, the thin film deposition method may also be used, for example, the deposition process such as chemical vapor deposition CVD, physical vapor deposition PVD, or atomic layer deposition ALD. For example, when the chemical vapor deposition CVD is used, an extra interface damage caused by ion bombardment on a surface of a thin film is not introduced. In addition, a thickness and uniformity of a formed isolation passivation layer can be precisely controlled through chemical vapor deposition CVD, so that the isolation passivation layer has low surface roughness.

Based on the foregoing descriptions of the processes of different layer structures in the ferroelectric capacitor, it can be learned that a process of manufacturing the first isolation passivation layer or the second isolation passivation layer herein may be compatible with a process of manufacturing the first electrode, the second electrode, or the ferroelectric layer. Therefore, a case in which another complex manufacturing process is introduced because the first isolation passivation layer and the second isolation passivation layer are added is avoided.

Step S02: Anneal the first electrode, the second electrode, the ferroelectric layer, the first isolation passivation layer, and the second isolation passivation layer, to obtain a ferroelectric capacitor including the first electrode, the second electrode, the ferroelectric layer, the first isolation passivation layer, and the second isolation passivation layer, where the first isolation passivation layer is configured to suppress diffusion of an oxygen element in the ferroelectric layer to the first electrode, and the second isolation passivation layer is configured to suppress diffusion of the oxygen element in the ferroelectric layer to the second electrode.

In other words, after the layer structures in the ferroelectric capacitor are completed, annealing needs to be performed on the ferroelectric capacitor to eliminate internal stresses in the layer structures.

That the first isolation passivation layer and the second isolation passivation layer are configured to suppress the diffusion of the oxygen element in the ferroelectric layer herein may be represented in at least three stages of the process: First, in a process of forming the ferroelectric layer after the first electrode and the first isolation passivation layer are completed, the oxygen element in the hafnium oxide based material may stay at the ferroelectric layer under blocking of the first isolation passivation layer, rather than diffusing to the first electrode due to a high temperature condition. Second, in a process of forming the second electrode after the first electrode, the first isolation passivation layer, the ferroelectric layer, and the second isolation passivation layer are completed, the oxygen element in the hafnium oxide based material does not diffuse to the formed second electrode due to a high temperature. Third, in an annealing process after the layer structures in the ferroelectric capacitor are completed, because of an isolation function of the first isolation passivation layer and the second isolation passivation layer, the oxygen element in the ferroelectric layer does not diffuse to the first electrode or the second electrode due to a high temperature condition.

The first isolation passivation layer may be made of an amorphous material, for example, may be made of titanium oxide (TiO₂), aluminum oxide (Al₂O₃), or tungsten oxide (WO₃) of an amorphous structure. The amorphous structure may provide a growth template for the ferroelectric layer, so that the ferroelectric layer grows into an orthorhombic crystalline crystal structure with good ferroelectricity, rather than growing into a ferroelectric thin film with a crystalline orientation consistent with that of the first electrode under impact of the first electrode.

Similarly, the second isolation passivation layer may also be made of the amorphous material. In this way, in a heat treatment process such as annealing, under the action of the second isolation passivation layer, a crystalline orientation of the ferroelectric layer is not affected by the second electrode either.

In some optional implementations, the method for forming the ferroelectric capacitor shown in FIG. 16 may be manufactured by using a back end of line (back end of line, BEOL) process. Therefore, a control circuit configured to control the ferroelectric capacitor may be manufactured on the substrate by using a front end of line (front end of line, FEOL) process. In other words, the control circuit is first formed on the substrate by using the front end of line process, and then the ferroelectric capacitor is obtained by using the back end of line process and the method shown in FIG. 16.

FIG. 17 is a diagram of a process structure of a memory cell in a ferroelectric field-effect transistor (ferroelectric field-effect transistor, FeFET) memory in ferroelectric memories. The memory cell includes a first doped area 100a and a second doped area 100b that are formed in a substrate 100, a channel area 100c located between the first doped area 100a and the second doped area 100b, a ferroelectric layer 03 formed on the channel area 100c, and a gate 07 that is formed on a side of the ferroelectric layer 03 away from the substrate 100. In addition, the memory cell further includes a first isolation passivation layer 04 formed between the ferroelectric layer 03 and the channel area 100c, and a second isolation passivation layer 05 formed between the ferroelectric layer 03 and the gate 07.

In some optional implementations, the substrate 100 may be a semiconductor substrate, for example, a P-type silicon substrate.

In the substrate 100, the first doped area 100a and the second doped area 100b that have a same doping type may be formed by using a doping process. For example, both the first doped area 100a and the second doped area 100b may be of an N type. One of the first doped area 100a and the second doped area 100b forms a source (Source), and the other doped area forms a drain (Drain).

For a material of the ferroelectric layer 03 in FIG. 17, refer to the optional materials of the ferroelectric layer 03 in FIG. 12. Details are not described herein again.

In some designs, the gate 07 may be made of poly-Si (p-Si, polycrystalline silicon), or may be made of a metal material. When the gate 07 is made of the metal material, the structure shown in FIG. 17 may be referred to as a metal-isolation passivation-ferroelectric-isolation passivation-semiconductor (metal-passivation-ferroelectric-passivation-semiconductor, MPFPS) memory cell structure.

For optional materials of the first isolation passivation layer 04 and the second isolation passivation layer 05 in FIG. 17, refer to the optional materials of the isolation passivation layer in FIG. 12. Details are not described herein again.

The first isolation passivation layer 04 in FIG. 17 can suppress diffusion of an oxygen element in the ferroelectric layer 03 to the channel area 100c. For example, when the channel area 100c can be made of a P-type silicon substrate, and the ferroelectric layer 03 can be made of hafnium oxide HfO₂, the first isolation passivation layer 04 may prevent the oxygen element in the ferroelectric layer 03 from diffusing to the silicon substrate. In comparison with a solution in which no the first isolation passivation layer 04 is disposed, in this solution, a quantity of ferroelectric phase grains in the ferroelectric layer 03 may be increased, thereby improving ferroelectric performance of the FeFET.

The second isolation passivation layer 05 in FIG. 17 is configured to suppress diffusion of the oxygen element in the ferroelectric layer 03 to the gate 07. Similarly, the quantity of ferroelectric phase grains in the ferroelectric layer 03 may be increased, to prevent a phenomenon of electricity leakage that occurs because the ferroelectric layer 03 is in an oxygen-deficient state.

In some implementations, amorphous TiO₂ may be selected for at least one of the first isolation passivation layer 04 and the second isolation passivation layer 05. When the ferroelectric layer 03 is formed by using a hafnium oxide based material, amorphous TiO₂ can not only suppress the diffusion of the oxygen element in the ferroelectric layer 03, but also prevent a crystalline orientation of the formed ferroelectric layer 03 from being affected by a crystalline orientation of the channel area 100c. In this way, a crystalline phase of the ferroelectric layer 03 formed by using the hafnium oxide based material can form an orthorhombic crystalline phase that can present good ferroelectricity. Certainly, at least one of the first isolation passivation layer 04 and the second isolation passivation layer 05 may include an orthorhombic crystalline phase structure; or at least one of the first isolation passivation layer 04 and the second isolation passivation layer 05 may include an amorphous structure and an orthorhombic crystalline phase structure, so that the ferroelectric layer 03 presents an orthorhombic crystalline phase.

The memory cell shown in FIG. 17 further includes a word line WL, a bit line BL, and a source line SL. The gate 07 is electrically connected to the word line WL, the first doped area 100a is electrically connected to the bit line BL, and the second doped area 100b is electrically connected to the source line SL.

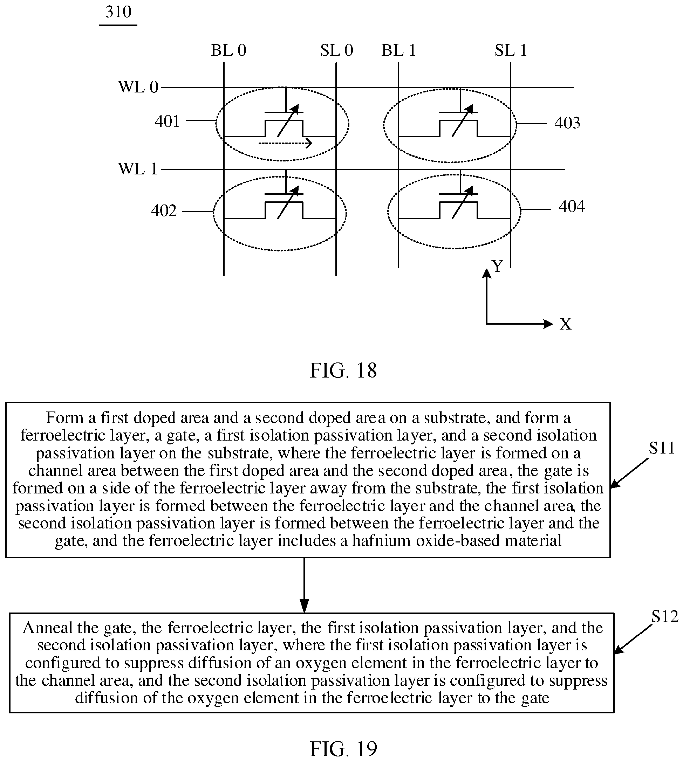

FIG. 18 is a circuit diagram of a memory array 310 including the memory cell shown in FIG. 17. In addition, for example, the memory array 310 shown in FIG. 18 shows four memory cells: a memory cell 401, a memory cell 402, a memory cell 403, and a memory cell 404, and word lines WLs extend in an X direction, so that gates of a plurality of memory cells arranged in the X direction are electrically connected to a same word line WL. In addition, bit lines BLs extend in a Y direction perpendicular to the X direction. In this way, first doped areas 100a of a plurality of memory cells arranged in the Y direction are electrically connected to a same bit line BL. Source lines SLs extend in the Y direction perpendicular to the X direction, and second doped areas 100b of the plurality of memory cells arranged in the Y direction are electrically connected to a same source line SL.

This application further provides a method for forming the foregoing memory cell shown in FIG. 17. FIG. 19 is an implementable flowchart of the forming method. Specific steps are as follows.

S11: Form a first doped area and a second doped area in a substrate, and form a ferroelectric layer, a gate, a first isolation passivation layer, and a second isolation passivation layer on the substrate, where the ferroelectric layer is formed on a channel area between the first doped area and the second doped area, the gate is formed on a side of the ferroelectric layer away from the substrate, the first isolation passivation layer is formed between the ferroelectric layer and the channel area, the second isolation passivation layer is formed between the ferroelectric layer and the gate, and the ferroelectric layer includes a hafnium oxide based material.

In a process, for doping types of the first doped area and the second doped area, optional materials of the first isolation passivation layer and the second isolation passivation layer, and optional materials of the ferroelectric layer, refer to the related descriptions of the materials selected for the layer structures in the descriptions of the structure shown in FIG. 17.

When the gate or the ferroelectric layer is formed, a magnetron sputtering deposition method may be used, or a thin film deposition method may be used, for example, a deposition process such as chemical vapor deposition (chemical vapor deposition, CVD), physical vapor deposition (physical vapor deposition, PVD), or atomic layer deposition (atomic layer deposition, ALD).

When the first isolation passivation layer or the second isolation passivation layer is formed, the thin film deposition method may also be used, for example, the deposition process such as chemical vapor deposition CVD, physical vapor deposition PVD, or atomic layer deposition ALD. In other words, a process of manufacturing the first isolation passivation layer and the second isolation passivation layer may be compatible with a process of manufacturing the gate and the ferroelectric layer. In this way, a case in which a method for manufacturing the memory is complex because the first isolation passivation layer and the second isolation passivation layer are introduced is avoided.

Step S12: Anneal the gate, the ferroelectric layer, the first isolation passivation layer, and the second isolation passivation layer, where the first isolation passivation layer is configured to suppress diffusion of an oxygen element in the ferroelectric layer to the channel area, and the second isolation passivation layer is configured to suppress diffusion of the oxygen element in the ferroelectric layer to the gate.

Similarly, that the first isolation passivation layer and the second isolation passivation layer are configured to suppress the diffusion of the oxygen element in the ferroelectric layer herein may be represented in at least three stages of the process: First, in a process of forming the ferroelectric layer after the first isolation passivation layer and doping of the first doped area and the second doped area are completed, an oxygen element in a ferroelectric material may stay at the ferroelectric layer under blocking of the first isolation passivation layer, rather than diffusing to the channel area due to a high temperature condition. Second, in a process of forming the gate after the first isolation passivation layer, the ferroelectric layer, and the second isolation passivation layer are completed, the oxygen element in the ferroelectric layer does not diffuse to the formed gate due to a high temperature. Third, in an annealing process after the layer structures in the ferroelectric capacitor are completed, similarly, because of an isolation function of the first isolation passivation layer and the second isolation passivation layer, the oxygen element in the ferroelectric layer does not diffuse to the gate and the channel area due to a high temperature condition.

To enable the ferroelectric layer 03 to have an orthorhombic crystalline phase structure with good ferroelectricity, the first isolation passivation layer 04 and the second isolation passivation layer 05 may be made of an amorphous material. The amorphous first isolation passivation layer 04 and second isolation passivation layer 05 are used to form, for the ferroelectric layer 03, a growing template that can be used for preferably selecting an orientation, so that the ferroelectric layer 03 can grow into an orthorhombic crystalline phase structure.

In the descriptions of this specification, the specific features, structures, materials, or characteristics may be combined in an appropriate manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A ferroelectric memory, comprising:
a substrate; and
a plurality of memory cells, formed on the substrate, wherein each memory cell comprises a ferroelectric capacitor, wherein
the ferroelectric capacitor comprises:
a first electrode and a second electrode that are stacked;
a ferroelectric layer, formed between the first electrode and the second electrode, wherein the ferroelectric layer comprises a hafnium oxide based material;
a first isolation passivation layer, formed between the first electrode and the ferroelectric layer; and
a second isolation passivation layer, formed between the second electrode and the ferroelectric layer, wherein
the first isolation passivation layer is configured to suppress diffusion of an oxygen element in the ferroelectric layer to the first electrode, and the second isolation passivation layer is configured to suppress diffusion of the oxygen element in the ferroelectric layer to the second electrode.

2. The ferroelectric memory according to claim 1, wherein the first isolation passivation layer and/or the second isolation passivation layer comprise/comprises a metal material having chemical inertia;
chemical inertia of the first isolation passivation layer is greater than both chemical inertia of the ferroelectric layer and chemical inertia of the first electrode; and
chemical inertia of the second isolation passivation layer is greater than both the chemical inertia of the ferroelectric layer and chemical inertia of the second electrode.

3. The ferroelectric memory according to claim 1 or 2, wherein the first isolation passivation layer and/or the second isolation passivation layer comprise/comprises at least one of metal oxide and a metal simple substance.

4. The ferroelectric memory according to any one of claims 1 to 3, wherein the first isolation passivation layer and/or the second isolation passivation layer comprise/comprises at least one of titanium oxide, tungsten oxide, tantalum oxide, niobium oxide, aluminum oxide, magnesium oxide, cerium oxide, platinum, or palladium.

5. The ferroelectric memory according to claim 1 or 2, wherein
the first isolation passivation layer comprises an amorphous structure and/or an orthorhombic crystalline phase structure;
the second isolation passivation layer comprises the amorphous structure and/or the orthorhombic crystalline phase structure; and
the first isolation passivation layer is further configured to suppress impact of the first electrode on a crystalline orientation of the ferroelectric layer, the second isolation passivation layer is further configured to suppress impact of the second electrode on the crystalline orientation of the ferroelectric layer, and the first isolation passivation layer and the second isolation passivation layer enable the ferroelectric layer to present an orthorhombic crystalline phase.

6. The ferroelectric memory according to claim 5, wherein the first isolation passivation layer and/or the second isolation passivation layer comprise/comprises at least one of titanium oxide, tungsten oxide, and aluminum oxide.

7. The ferroelectric memory according to any one of claims 1 to 6, wherein the first electrode, the first isolation passivation layer, the ferroelectric layer, the second isolation passivation layer, and the second electrode are stacked in a direction perpendicular to the substrate.

8. The ferroelectric memory according to any one of claims 1 to 6, wherein the first electrode, the first isolation passivation layer, the ferroelectric layer, the second isolation passivation layer, and the second electrode are stacked in a direction parallel to the substrate.

9. The ferroelectric memory according to any one of claims 1 to 8, wherein each memory cell further comprises a first transistor, a second transistor, a control line, a write bit line, a read bit line, a source line, and a word line, wherein
a control end of the first transistor is electrically connected to the control line, a first end of the first transistor is electrically connected to the first electrode, and a second end of the first transistor is electrically connected to the write bit line;
a control end of the second transistor is electrically connected to the first electrode, a first end of the second transistor is electrically connected to the source line, and a second end of the second transistor is electrically connected to the read bit line; and
the second electrode is electrically connected to the word line.

10. The ferroelectric memory according to any one of claims 1 to 9, wherein a thickness of the first isolation passivation layer and/or a thickness of the second isolation passivation layer in a stacking direction of the first electrode and the second electrode are/is 0.5 nm to 5 nm.

11. A ferroelectric memory, comprising:
a substrate; and
a plurality of memory cells, formed on the substrate, wherein each memory cell comprises a ferroelectric capacitor, wherein
the ferroelectric capacitor comprises:
a first electrode and a second electrode that are stacked;
a ferroelectric layer, formed between the first electrode and the second electrode, wherein the ferroelectric layer comprises a hafnium oxide based material;
a first isolation passivation layer, formed between the first electrode and the ferroelectric layer; and
a second isolation passivation layer, formed between the second electrode and the ferroelectric layer, wherein
the first isolation passivation layer and/or the second isolation passivation layer comprise/comprises at least one of titanium oxide, tungsten oxide, tantalum oxide, niobium oxide, aluminum oxide, magnesium oxide, cerium oxide, platinum, and palladium.

12. The ferroelectric memory according to claim 11, wherein
the first isolation passivation layer comprises an amorphous structure and/or an orthorhombic crystalline phase structure;
the second isolation passivation layer comprises the amorphous structure and/or the orthorhombic crystalline phase structure; and
the first isolation passivation layer is further configured to suppress impact of the first electrode on a crystalline orientation of the ferroelectric layer, the second isolation passivation layer is further configured to suppress impact of the second electrode on the crystalline orientation of the ferroelectric layer, and the first isolation passivation layer and the second isolation passivation layer enable the ferroelectric layer to present an orthorhombic crystalline phase.

13. The ferroelectric memory according to claim 11 or 12, wherein the first electrode, the first isolation passivation layer, the ferroelectric layer, the second isolation passivation layer, and the second electrode are stacked in a direction perpendicular to the substrate.

14. The ferroelectric memory according to claim 11 or 12, wherein the first electrode, the first isolation passivation layer, the ferroelectric layer, the second isolation passivation layer, and the second electrode are stacked in a direction parallel to the substrate.

15. The ferroelectric memory according to any one of claims 11 to 14, wherein each memory cell further comprises a first transistor, a second transistor, a control line, a write bit line, a read bit line, a source line, and a word line, wherein
a control end of the first transistor is electrically connected to the control line, a first end of the first transistor is electrically connected to the first electrode, and a second end of the first transistor is electrically connected to the write bit line;
a control end of the second transistor is electrically connected to the first electrode, a first end of the second transistor is electrically connected to the source line, and a second end of the second transistor is electrically connected to the read bit line; and
the second electrode is electrically connected to the word line.

16. The ferroelectric memory according to any one of claims 11 to 15, wherein a thickness of the first isolation passivation layer and/or a thickness of the second isolation passivation layer in a stacking direction of the first electrode and the second electrode are/is 0.5 nm to 5 nm.

17. A method for forming a ferroelectric memory, wherein the forming method comprises:
forming a first electrode, a second electrode, a ferroelectric layer, a first isolation passivation layer, and a second isolation passivation layer on a substrate, wherein the ferroelectric layer is formed between the first electrode and the second electrode, the first isolation passivation layer is formed between the first electrode and the ferroelectric layer, the second isolation passivation layer is formed between the second electrode and the ferroelectric layer, and the ferroelectric layer is made of a material comprising a hafnium oxide based material; and
annealing the first electrode, the second electrode, the ferroelectric layer, the first isolation passivation layer, and the second isolation passivation layer, to obtain a ferroelectric capacitor comprising the first electrode, the second electrode, the ferroelectric layer, the first isolation passivation layer, and the second isolation passivation layer, wherein the first isolation passivation layer is configured to suppress diffusion of an oxygen element in the ferroelectric layer to the first electrode, and the second isolation passivation layer is configured to suppress diffusion of the oxygen element in the ferroelectric layer to the second electrode.

18. The method for forming the ferroelectric memory according to claim 17, wherein forming the first isolation passivation layer and/or the second isolation passivation layer comprises: the first isolation passivation layer and the second isolation passivation layer are made of a metal material comprising chemical inertia, wherein
chemical inertia of the first isolation passivation layer is greater than both chemical inertia of the ferroelectric layer and chemical inertia of the first electrode; and
chemical inertia of the second isolation passivation layer is greater than both the chemical inertia of the ferroelectric layer and chemical inertia of the second electrode.

19. The method for forming the ferroelectric memory according to claim 17 or 18, wherein forming the first isolation passivation layer and/or the second isolation passivation layer comprises: the first isolation passivation layer and the second isolation passivation layer are made of at least one of metal oxide and a metal simple substance.

20. The method for forming the ferroelectric memory according to any one of claims 17 to 19, wherein forming the first isolation passivation layer and/or the second isolation passivation layer comprises: the first isolation passivation layer and the second isolation passivation layer are made of an amorphous material.

21. A ferroelectric memory, comprising:
a substrate; and
a plurality of memory cells, formed on the substrate, wherein each memory cell comprises:
a first doped area and a second doped area that are formed in the substrate;
a channel area, located between the first doped area and the second doped area;
a ferroelectric layer, formed on the channel area, wherein the ferroelectric layer comprises a hafnium oxide based material;
a gate, formed on a side of the ferroelectric layer away from the substrate;
a first isolation passivation layer, formed between the ferroelectric layer and the channel area; and
a second isolation passivation layer, formed between the ferroelectric layer and the gate, wherein
the first isolation passivation layer is configured to suppress diffusion of an oxygen element in the ferroelectric layer to the channel area, and the second isolation passivation layer is configured to suppress diffusion of the oxygen element in the ferroelectric layer to the gate.

22. The ferroelectric memory according to claim 21, wherein the first isolation passivation layer and/or the second isolation passivation layer comprise/comprises a metal material having chemical inertia;
chemical inertia of the first isolation passivation layer is greater than both chemical inertia of the ferroelectric layer and chemical inertia of the channel area; and
chemical inertia of the second isolation passivation layer is greater than both the chemical inertia of the ferroelectric layer and chemical inertia of the gate.

23. The ferroelectric memory according to claim 21 or 22, wherein the first isolation passivation layer and/or the second isolation passivation layer comprise/comprises at least one of metal oxide and a metal simple substance.

24. The ferroelectric memory according to any one of claims 21 to 23, wherein the first isolation passivation layer and/or the second isolation passivation layer comprise/comprises at least one of titanium oxide, tungsten oxide, tantalum oxide, niobium oxide, aluminum oxide, magnesium oxide, cerium oxide, platinum, and palladium.

25. The ferroelectric memory according to claim 21 or 22, wherein
the first isolation passivation layer comprises an amorphous structure and/or an orthorhombic crystalline phase structure;
the second isolation passivation layer comprises the amorphous structure and/or the orthorhombic crystalline phase structure; and
the first isolation passivation layer is further configured to suppress impact of the channel area on a crystalline orientation of the ferroelectric layer, the second isolation passivation layer is further configured to suppress impact of the gate on the crystalline orientation of the ferroelectric layer, and the first isolation passivation layer and the second isolation passivation layer enable the ferroelectric layer to present an orthorhombic crystalline phase.

26. The ferroelectric memory according to claim 25, wherein the first isolation passivation layer and/or the second isolation passivation layer comprise/comprises at least one of titanium oxide, tungsten oxide, and aluminum oxide.

27. The ferroelectric memory according to any one of claims 21 to 26, wherein each memory cell further comprises a word line, a bit line, and a source line, wherein
the gate is electrically connected to the word line, the first doped area is electrically connected to the bit line, and the second doped area is electrically connected to the source line.

28. The ferroelectric memory according to any one of claims 21 to 27, wherein a thickness of the first isolation passivation layer and/or a thickness of the second isolation passivation layer in a stacking direction of the ferroelectric layer and the gate are/is 0.5 nm to 5 nm.

29. A ferroelectric memory, comprising:
a substrate; and
a plurality of memory cells, formed on the substrate, wherein each memory cell comprises:
a first doped area and a second doped area that are formed in the substrate;
a channel area, located between the first doped area and the second doped area;
a ferroelectric layer, formed on the channel area, wherein the ferroelectric layer comprises a hafnium oxide based material;
a gate, formed on a side of the ferroelectric layer away from the substrate;
a first isolation passivation layer, formed between the ferroelectric layer and the channel area; and
a second isolation passivation layer, formed between the ferroelectric layer and the gate, wherein
the first isolation passivation layer and/or the second isolation passivation layer comprise/comprises at least one of titanium oxide, tungsten oxide, tantalum oxide, niobium oxide, aluminum oxide, magnesium oxide, cerium oxide, platinum, and palladium.

30. The ferroelectric memory according to claim 29, wherein
the first isolation passivation layer comprises an amorphous structure and/or an orthorhombic crystalline phase structure;
the second isolation passivation layer comprises the amorphous structure and/or the orthorhombic crystalline phase structure; and
the first isolation passivation layer is further configured to suppress impact of the channel area on a crystalline orientation of the ferroelectric layer, the second isolation passivation layer is further configured to suppress impact of the gate on the crystalline orientation of the ferroelectric layer, and the first isolation passivation layer and the second isolation passivation layer enable the ferroelectric layer to present an orthorhombic crystalline phase.

31. The ferroelectric memory according to claim 29 or 30, wherein each memory cell further comprises a word line, a bit line, and a source line, wherein
the gate is electrically connected to the word line, the first doped area is electrically connected to the bit line, and the second doped area is electrically connected to the source line.

32. The ferroelectric memory according to any one of claims 29 to 31, wherein a thickness of the first isolation passivation layer and/or a thickness of the second isolation passivation layer in a stacking direction of the ferroelectric layer and the gate are/is 0.5 nm to 5 nm.

33. A method for forming a ferroelectric memory, wherein the forming method comprises:
forming a first doped area and a second doped area in a substrate, and forming a ferroelectric layer, a gate, a first isolation passivation layer, and a second isolation passivation layer on the substrate, wherein the ferroelectric layer is formed on a channel area between the first doped area and the second doped area, the gate is formed on a side of the ferroelectric layer away from the substrate, the first isolation passivation layer is formed between the ferroelectric layer and the channel area, the second isolation passivation layer is formed between the ferroelectric layer and the gate, and the ferroelectric layer comprises a hafnium oxide based material; and
annealing the gate, the ferroelectric layer, the first isolation passivation layer, and the second isolation passivation layer, wherein the first isolation passivation layer is configured to suppress diffusion of an oxygen element in the ferroelectric layer to the channel area, and the second isolation passivation layer is configured to suppress diffusion of the oxygen element in the ferroelectric layer to the gate.

34. The method for forming the ferroelectric memory according to claim 33, wherein forming the first isolation passivation layer and/or the second isolation passivation layer comprises: the first isolation passivation layer and the second isolation passivation layer are made of a metal material comprising chemical inertia, wherein
chemical inertia of the first isolation passivation layer is greater than both chemical inertia of the ferroelectric layer and chemical inertia of the channel area; and
chemical inertia of the second isolation passivation layer is greater than both the chemical inertia of the ferroelectric layer and chemical inertia of the gate.

35. The method for forming the ferroelectric memory according to claim 33 or 34, wherein forming the first isolation passivation layer and/or the second isolation passivation layer comprises: the first isolation passivation layer and the second isolation passivation layer are made of at least one of metal oxide and a metal simple substance.

36. The method for forming the ferroelectric memory according to any one of claims 33 to 35, wherein forming the first isolation passivation layer and the second isolation passivation layer comprises: the first isolation passivation layer and the second isolation passivation layer are made of an amorphous material.

37. An electronic device, comprising:
a processor; and
the ferroelectric memory according to any one of claims 1 to 16, the ferroelectric memory manufactured by using the method for forming the ferroelectric memory according to any one of claims 17 to 20, the ferroelectric memory according to any one of claims 21 to 32, or the ferroelectric memory manufactured by using the method for forming the ferroelectric memory according to any one of claims 33 to 36, wherein
the processor is electrically connected to the ferroelectric memory.
